(19) Europäisches Patentamt
European Patent Office
Office européen des brevets

(11) **EP 4 693 895 A1**

(12) **EUROPEAN PATENT APPLICATION**

(43) Date of publication:
**11.02.2026 Bulletin 2026/07**

(21) Application number: **25190843.0**

(22) Date of filing: **22.07.2025**

(51) International Patent Classification (IPC):
**H03B 21/00** (2006.01)     **H03B 28/00** (2006.01)

(52) Cooperative Patent Classification (CPC):
**H03B 28/00; H03B 21/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.08.2024 US 202418795300**

(71) Applicant: **NXP B.V.**
**5656 AG Eindhoven (NL)**

(72) Inventors:
• **van Veldhoven, Robert**
**5656AG Eindhoven (NL)**
• **Rout, Samprajani**
**5656AG Eindhoven (NL)**
• **Molendijk, Maarten Jelmar**
**5656AG Eindhoven (NL)**

(74) Representative: **Colaiuda, Antonella**
**NXP Semiconductors Germany GmbH**
**Intellectual Property Group**
**Beiersdorfstraße 12**
**22529 Hamburg (DE)**

(54) **SINE-WAVE GENERATOR INCLUDING FINITE IMPULSE RESPONSE FILTER-BASED HARMONIC CANCELLATION**

(57)     Devices and methods may include receiving a square wave having a frequency at an input of a harmonic-cancellation (HC) sine-wave generator; receiving a clock signal having a clock frequency at a clock input of the HC sine-wave generator; generating one or more delayed square waves based on the received square wave and the clock signal using one or more delay components of the HC sine-wave generator; and amplitude-scaling the square wave and the one or more delayed square waves using a plurality of taps of the HC sine-wave generator to produce a plurality of amplitude-scaled square waves. The method may include adding the plurality of amplitude-scaled square waves using summing circuitry of the HC sine-wave generator to produce a sine wave having tone at the frequency with suppressed signal strength at selected harmonics of the frequency of the square wave at an output terminal of the HC sine-wave generator.

FIG. 2

**Description**

FIELD OF USE

The present disclosure generally relates to signal generators, and more particularly to semiconductor devices, systems, and methods configured to generate one or more tones with canceled or suppressed energy at harmonics of a frequency of an input square wave using mixed-signal finite impulse response filter-based harmonic canceling.

BACKGROUND

A high-linearity area-efficient sine-wave generator is required for mixed-signal IP testing. Other applications of sine-wave generators include bioimpedance measurement for cancer diagnosis, body composition analysis, and electrochemical applications, such as lithium-battery evaluation, fuel-cell-condition monitoring and protective coating evaluation.

One approach to implementing a high-linearity sine-wave generator may include analog filtering with a high-order low-pass or band-pass filter. A high-order low-pass or band-pass filter may require a steep transition band, and higher-order filters may need to be made stable. The disadvantages of this approach may include complexity and limited attenuation of the in-band harmonics.

A second approach may include implementation of a look-up table including the precise values of the sinewave and a high-resolution conventional digital-to-analog converter (DAC). This approach may have the disadvantage of requiring a relatively large hardware overhead in terms of circuit area and a relatively high-power consumption.

BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.

FIG. 1A depicts a block diagram of an embodiment of a system including a sinewave generator including a finite impulse response (FIR) filter configured to provide harmonic cancellation, in accordance with certain embodiments of the present disclosure.

FIG. 1B depicts a block diagram representing operation of the system of FIG. 1A, in accordance with certain embodiments of the present disclosure.

FIG. 2 depicts a block diagram of an embodiment of a sine-wave generator based on a finite impulse response (FIR) filter to provide harmonic canceling, in accordance with certain embodiments of the present disclosure.

FIG. 3 depicts a partial block diagram and partial circuit diagram of an embodiment of a semiconductor device including a circuit implementation of the sine-wave generator of FIG. 2 based on FIR notch filtering, in accordance with certain embodiments of the present disclosure.

FIG. 4 depicts a block diagram of an embodiment of a two-tone generator including two FIR filters configured to provide harmonic cancellation, in accordance with certain embodiments of the present disclosure.

FIG. 5 depicts a block diagram of an embodiment of the two-tone generator of FIG. 4 including two FIR filters to provide harmonic cancellation, in accordance with certain embodiments of the present disclosure.

FIG. 6 depicts a partial block diagram and partial circuit diagram of an embodiment of the two-tone generator of FIGs. 4 and 5 based on FIR notch filtering including a passive resistor-capacitor (RC) filter at the output, in accordance with certain embodiments of the present disclosure.

FIG. 7A depicts a diagram of an input square wave and a set of delayed square waves in a time domain, in accordance with certain embodiments of the present disclosure.

FIG. 7B depicts a graph of the output spectrum (amplitude in decibel units of voltage versus frequency in Hertz showing the power spectral density (PSD) of the input square wave of FIG. 7A, in accordance with certain embodiments of the present disclosure.

FIG. 8A depicts a graph of amplitude versus sample number of the summed square waves of FIG. 7A in the time domain, in accordance with certain embodiments of the present disclosure.

FIG. 8B depicts a graph of the power spectral density (PSD) in decibels versus frequency in Hertz, in the frequency domain, for the summed waveform of FIG. 8A, in accordance with certain embodiments of the present disclosure.

FIG. 9A depicts a graph of the magnitude (dB) versus normalized frequency for an FIR filter with five notches at the third, fifth, seventh, and ninth harmonics and at half the clock frequency, in accordance with certain embodiments of the present disclosure.

FIG. 9B depicts a graph of the phase (in degrees) versus normalized frequency for an FIR filter with five notches at the third, fifth, seventh, and ninth harmonics and at half the clock frequency, in accordance with certain embodiments of the present disclosure.

FIG. 10A depicts a graph of the amplitude (in volts) versus time (samples) for the HC sine-wave generator depicting the input square wave and the output signal, in accordance with certain embodiments of the present disclosure.

FIG. 10B depicts a graph of the amplitude (in decibel units of voltage) versus frequency (in Hertz) for an FIR notch filter output in the frequency domain for the signals in FIG. 10A, in accordance with certain embodiments of the present disclosure.

FIG. 11A depicts a graph of the amplitude (in volts) versus time (samples) for the input and output signals in the time domain, in accordance with certain embodiments of the present disclosure.

FIG. 11B depicts a graph of the amplitude (in decibel units of voltage) versus frequency (in Hertz) for an FIR notch filter output in the frequency domain for the signals in FIG. 11A, in accordance with certain embodiments of the present disclosure.

FIG. 12A depicts a graph of the amplitude (in volts) versus time (samples) for the input and output signals in the time domain for a system having a mismatch between p-channel metal oxide semiconductor (PMOS) and n-channel (NMOS) switch resistances, in accordance with certain embodiments of the present disclosure.

FIG. 12B depicts a graph of the amplitude (in decibel units of voltage) versus frequency (in Hertz) for an FIR notch filter output in the frequency domain or the system of FIG. 12A, in accordance with certain embodiments of the present disclosure.

FIG. 13A depicts a graph of amplitude versus frequency in the frequency domain for an embodiment of a two-tone generator output having matched PMOS and NMOS resistances, in accordance with certain embodiments of the present disclosure.

FIG. 13B depicts a graph of amplitude versus frequency in the frequency domain for an embodiment of a two-tone generator output where the generator includes a mismatch in resistances between the PMOS and NMOS switches, in accordance with certain embodiments of the present disclosure.

FIG. 14A depicts a graph of amplitude versus frequency in the frequency domain for another embodiment of a two-tone generator output with matched PMOS and NMOS resistances, in accordance with certain embodiments of the present disclosure.

FIG. 14B depicts a graph of amplitude versus frequency in the frequency domain for another embodiment of a two-tone generator output with mismatched PMOS and NMOS resistances, in accordance with certain embodiments of the present disclosure.

FIG. 15A depicts a graph of amplitude versus frequency for the output spectra of the FIR filter with varying Fast Fourier Transform (FFT) filter values, in accordance with certain embodiments of the present disclosure.

FIG. 15B depicts an expanded view of a portion of the graph of FIG. 15A, in accordance with certain embodiments of the present disclosure.

FIG. 16 depicts an embodiment of a method of generating an output signal having a selected harmonic tone using a harmonic cancellation FIR filter, in accordance with certain embodiments of the present disclosure.

FIG. 17 depicts an embodiment of a method of generating an output signal having two harmonic tones using a pair of harmonic cancellation FIR filters, in accordance with certain embodiments of the present disclosure.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

DETAILED DESCRIPTION

Embodiments of circuits and methods are described below that use a harmonic cancellation (HC) technique to cancel harmonics to produce a desired output signal using mixed-signal finite impulse response (FIR) filters. HC is fully compatible with digital circuits with easy portability to advanced nodes and only requires easy to generate square-wave pulses.

In one or more embodiments, a sine-wave generator may be provided that is area-efficient (in terms of the amount of circuit area used to produce the output signal) and may be configured to produce an output signal with high-linearity. Using a square-wave as an input, the sine-wave generator may be configured to produce delayed versions of the square-wave, to scale the delayed version using well-defined coefficients, and to sum the scaled and delayed versions of the square-wave to produce an output signal with unwanted energy suppressed at harmonics of the input square wave.

Square-wave signals with a fifty percent (50%) duty-cycle may produce only odd-order harmonics, which may be suppressed using notch filters configured for the odd-order harmonics. By changing the clock rate $f_{clk}$, the location of the zeros (notches) can be varied to place notches at selected frequencies, such as at odd-order harmonics of a frequency of the input square wave. In some embodiments, an HC sine-wave generator may include a plurality of taps and the number of taps may determine the number of notches. Based on the number and the location of the notches, odd-order harmonics occurring at the notch frequency (location) may be eliminated. If the square-wave is perfectly symmetrical (50% duty cycle), only odd-order harmonics are generated. In the case of asymmetry in the square-wave (not precisely a 50% duty cycle) leading to the generation of even-order harmonics, notches can also be placed at even-order harmonics thus may be eliminated. In one or more embodiments, the sine-wave generator may be programmable for various input frequencies. In one or more embodiments, the energy at odd-order harmonics may be further suppressed by a passive resistor-capacitor (RC) filter, which may be provided after the FIR filter.

In one or more embodiments, the sine-wave generator may be configured to utilize one or more harmonic cancellation (HC) FIR filters to produce two tones. In one or more embodiments, the two HC FIR filters may be driven by two input square waves having equal or different clock frequencies and may use a set of coefficients that are the same or different to generate two-tone sine waves.

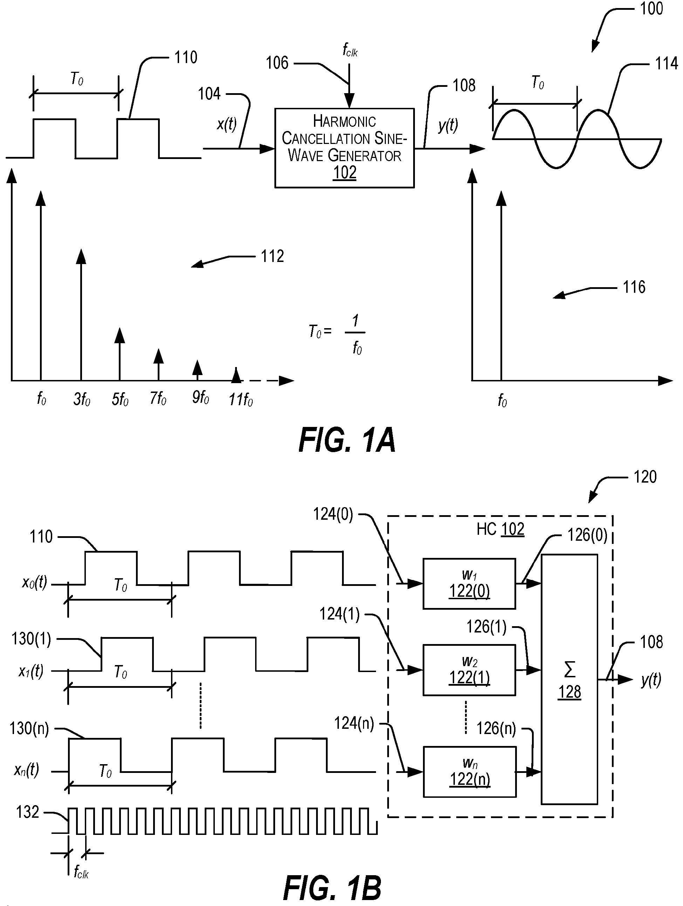

In one or more embodiments, an HC FIR filter circuit may include an input to receive a square-wave input, a clock input to receive a clock signal having a selected clock frequency $f_{clk}$, and an output to provide a highly linear sine wave of the same frequency or at a harmonic corresponding to the input square-wave. In one or more embodiments, the HC FIR filter may be configured to eliminate a fundamental tone of the square-wave input while keeping a selected harmonic. An example of an HC sine-wave generator is described below with respect to FIG. 1A.

FIG. 1A depicts a block diagram of an embodiment of a system 100 including a harmonic canceling (HC) sine-wave generator 102 including a finite impulse response (FIR) filter configured to provide harmonic cancellation, in accordance with certain embodiments of the present disclosure. The HC sine-wave generator 102 may include an input 104 to receive an input signal x(t), such as a square-wave 110. The generator 102 may include a clock input 106 to receive a clock signal having a clock frequency $f_{clk}$. The HC sine-wave generator 102 may include an output terminal 108 configured to provide an output signal $y(t)$, such as the sine wave 114.

The square wave 110 may have a time period $T_0$, and the output signal 114 may have the same time period $T_0$. In the illustrated example, the square wave 110 is shown in the frequency domain at 112. By virtue of symmetry, the square wave 110 may have a fifty percent (50%) duty cycle, and the frequency domain 112 of the square wave 110 has signal components at the fundamental frequency $f_0$ of the square wave 110 and at odd harmonics $3f_0$, $5f_0$, $7f_0$, $9f_0$, and $11f_0$ of the fundamental frequency $f_0$. The HC sine-wave generator 102 may be configured to eliminate or suppress the odd-order harmonics of the square-wave 110 to produce the output signal $y(t)$. In one or more embodiments, the HC sine-wave generator 102 may also be configured to eliminate or suppress even-order harmonics of the square wave 110. In the illustrate example, the sine wave 114 may be the output signal $y(t)$ at the output terminal 108 and, ideally, in the frequency domain 116, the sine wave 114 may have a frequency component only at the fundamental frequency $f_0$.

In one or more embodiments, the HC sine-wave generator 102 may use the input signal to produce multiple delayed versions of the square wave, which may be scaled and added together to provide, to the output terminal 108, the output signal $y(t)$, which may have a selected frequency component at the fundamental frequency $f_0$ or at a selected harmonic of the fundamental frequency $f_0$. An embodiment of the HC sine-wave generator 102 including scaling and summing components is described below with respect to FIG. 1B.

FIG. 1B depicts a block diagram 120 representing operation of the system 100 of FIG. 1A, in accordance with certain embodiments of the present disclosure. In the block diagram 120, the HC sine-wave generator 102 be configured to receive a square wave 110 having a time period $T_0$, to receive a clock signal 132 having a clock frequency $f_{clk}$, and to provide, to the output terminal 108, an output signal $y(t)$ having suppressed energy at selected harmonics of the square wave 110. The HC sine-wave generator 102 may be configured to generate delayed square waves 130 based on the square wave 110, apply a selected weight to each of the square wave 110 and the delayed square waves 130 to produce amplitude-scaled square waves, which may be added together to produce the output signal $y(t)$ at the output terminal 108.

In one or more embodiments, the HC sine-wave generator 102 may include a plurality of weighting (scaling) components 122, each of which may include an input terminal 124 to receive the square wave 110 or a delayed square wave 130(1), ..., 130(n) and an output terminal 126 to provide an amplitude-scaled square waves based on one of the square wave 110 or the delayed square wave 130. The HC sine-wave generator 102 may include summing circuitry 128 including a plurality of inputs coupled to the output terminals 126 of the weighting components 122 and including an output coupled to the output terminal 108 to provide the output signal $y(t)$. The summing circuitry 128 may be configured to add each of the amplitude-scaled square wave based on one of the input square wave 110 and the delayed square waves 130 to produce the output signal $y(t)$.

The plurality of weighting components 122 may include a first weighting component 122(0) configured to receive the input signal x(t) corresponding to the square wave 110, and one or more second weighting components 122(1), 122(2), ..., 122(n) to receive one or more delayed input signals $x_1(t)$, ..., $x_n(t)$ of the input signal $x(t)$ corresponding to the delayed square waves 130(1),.., 130(n). Each of the delayed versions $x_1(t)$, ..., $x_n(t)$ of the input signal $x(t)$ may have the same time period $T_0$ and may be offset in time (delayed) relative to the input signal $x(t)$ and relative to others of the delayed versions. In the illustrated example, only two delayed versions $x_1(t)$ and $x_n(t)$ of the input signal $x(t)$ are shown; however, any number $n$ of delayed versions of the input signal $x(t)$ may be generated.

In the illustrated example, the input signal $x(t)$ may correspond to the square wave 110, the delayed version $x_1(t)$ may correspond to the square wave 130(1), and the delayed version $x_n(t)$ may correspond to the square wave 130(n). Any number of delayed square waves 130 may be generated. Each of the square wave 110 and the delayed square waves 130 have the same period $T_0$. Each delayed square wave 130 is offset from the square wave 110 or from other delayed square waves 130 by a selected or programmed delay. In one or more embodiments, in an alternative example, to cancel the third harmonic of the square wave 110, a second square wave having a frequency that is three times greater than the frequency of the square wave 110 may be used and a scaled version of the higher frequency square wave may be subtracted from the square wave 110 to place a notch at the third harmonic. In one or more embodiments, the selected or programmed delay may be the same (or approximately the same within a margin of error of manufacturing tolerances) for each of the delayed square waves 130 such that the delayed square waves 130 are offset from one another by the same delay.

Each weighting component 122 may include an input terminal 124 and an output terminal 126. Each weighting component 122 may be configured to receive, at the input terminal 124, one of the square wave 110 or a delayed square wave 130. The first weighting component 122(0) may receive the clock signal 110 and other weighting components 122(1), ..., 122(n) may receive one of the delayed square waves 130(1), ..., 130(n). Each weighting component 122 may be configured to scale the associated square wave 110 or delayed square wave 130 in terms of amplitude by an associated weight ($w_0$, $w_1$, ... $w_n$) to produce an amplitude-scaled square wave. Each weighting component 122 may provide the amplitude-scaled square wave to the output terminal 126, which may be coupled to a corresponding input of the summing circuitry 128. The summing circuitry 128 may include a plurality of input terminals coupled to the output terminals 126 of the weighting components 122 and may be configured to add the amplitude-scaled square waves to produce the output signal $y(t)$, which may be provided to the output terminal 108. By adding the amplitude-scaled square waves, the summing circuitry 128 produces the output signal $y(t)$ with suppressed or canceled energy at selected harmonic frequencies corresponding to the timing of the edges of delayed square waves 130.

In one or more embodiments, the HC sine-wave generator 102 may be clocked using the clock signal 132 to provide the output signal $y(t)$. In one or more embodiments, the HC sine-wave generator 102 may include one or more delay components and FIR taps, which may be represented by a transfer function. The transfer function $H(z)$ of the $(n+1)^{th}$ tap FIR filter can be written as follows:

$$H(z) = b_0 + b_1 z^{-1} + \cdots + b_n z^{-n} \qquad (1)$$

where *b* represents a weight provided by a tap of the FIR filter, z represents a delay, and *n* represents the number of taps and associated delays. Equation 1 may be rewritten as follows:

$$H(z) = \sum_{i=0}^{n} b_i z^{-i} \qquad (2)$$

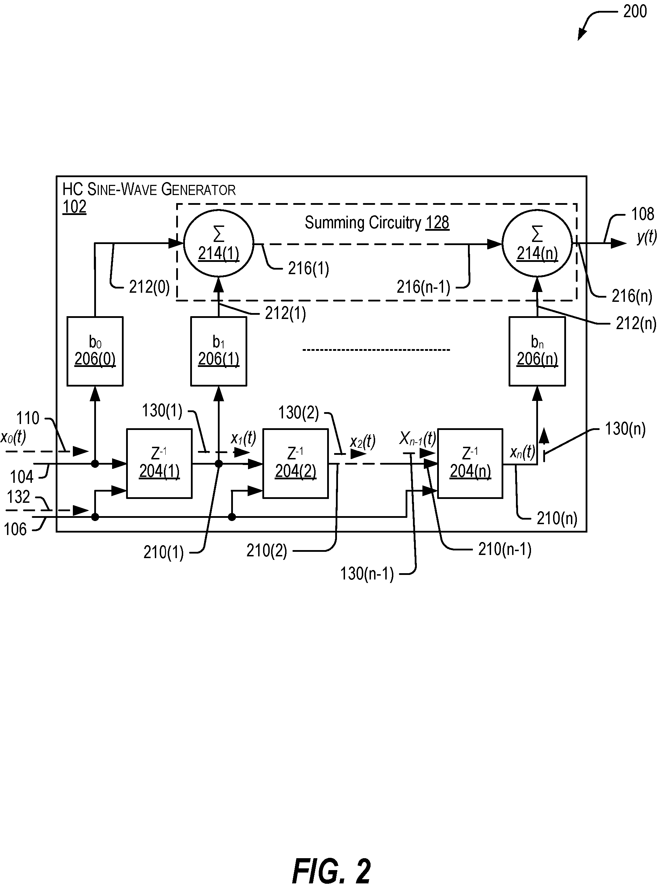

where *i* represents an index from zero (0) to the number of taps and associated delays *n*. An embodiment of an HC sine-wave generator based on the FIR filter topology described in equations 1 and 2 is described below with respect to FIG. 2.

FIG. 2 depicts a block diagram of a system 200 including an embodiment of an HC sine-wave generator 102 based on a finite impulse response (FIR) filter to provide harmonic canceling, in accordance with certain embodiments of the present disclosure. The HC sinewave generator 102 may include the input 104 configured to receive the square wave 110, the clock input 106 to receive the clock signal 132, and an output 108 to provide the output signal *y(t)*.

In one or more embodiments, the HC sine-wave generator 102 may include a plurality of delay components 204. A first delay component 204(1) may include a first input coupled to the input 104 to receive the square wave 110, a second input coupled to the clock input 106 to receive the clock signal 132, and an output coupled to a node 210(1). The first delay component 204(1) may be configured to generate a first delayed square wave 130(1) of the square wave 110 based on the clock signal 132 and to provide the delayed square wave 130(1) to the node 210(1). A second delay component 204(2) may include a first input coupled to the node 210(1) to receive the first delayed square wave 130(1), a second input coupled to the clock input 106 to receive the clock signal 132, and an output coupled to a node 210(2) to provide a second delayed square wave 130(2).

The HC sine-wave generator 102 may include one or more intermediate delay components 204 (not shown) (e.g., delay components 204(3), ..., 204(n-1)), each of which may produce a corresponding intermediate delayed square wave 130 (e.g., delayed square waves 130(3), ..., 130(n-1)). The HC sine-wave generator 102 may include an n-th delay component 204(n) including an input coupled to a node 210(n-1) to receive the delayed square wave 130(n-1), a second input coupled to the clock input 106 to receive the clock signal 132, an output coupled to the n-th node 210(n) to provide the n-th delayed square wave 130(n).

The HC sine-wave generator 102 may include a plurality of taps (weighting components) 206, which may correspond to or define the coefficients $b_0$, $b_1$, ..., $b_n$ in Equations 1 and 2. Each tap 206 may include an input coupled to a node, such as input 104 for a first tap 206(0) or one of the nodes 210 for other taps 206(1), ..., 206(n). Each tap 206 may include an output coupled to one of the nodes 212(0), 212(1), ..., and 212(n). Each tap 206 may be configured to apply a weight to a received signal (the square wave 110 for the tap 206(0) or a delayed square wave 130 for the taps 206(1), ..., 206(n) to produce an amplitude-scaled square wave and to provide the amplitude-scaled square wave to the corresponding node 212(0), 212(1), ..., or 212(n).

The HC sine-wave generator 102 may include summing circuitry 128, which may include one or more summing nodes 214 coupled between the nodes 212 at the output of the taps 206 and the output terminal 108 to provide an output signal *y(t)*. A first summing node 214(1) may include a first input coupled to a node 212(0), a second input coupled to the node 212(1), and an output coupled to an output node 216(1). Intermediate summing nodes 214 (not shown) may include a first input coupled to one of the output nodes 216, a second input coupled to one of the nodes 212, and an output coupled to another of the output nodes 216. The summing node 214(n) may include a first input coupled to the node 216(n-1), a second input coupled to the node 212(n), and output coupled to the node 216(n), which may be coupled to the output 108 to provide the output signal *y(t)*.

In the illustrated example, the HC sine-wave generator 102 may include a plurality of delay components 204(1), 204(2), ... 204(n). A first delay component 204(1) may include a first input coupled to the input 104 to receive the square wave 110, a second input coupled to the clock input 106 to receive the clock signal 132, and an output coupled to the node 210(1) to provide a first delayed square wave 130(1). A second delay component 204(2) may include a first input coupled to the node 210(1) to receive the first delayed square wave 130(1), a second input coupled to the clock input 106 to receive the clock signal 132, and an output coupled to the node 210(2) to provide a second delayed square wave 130(2). The HC sine-wave generator 102 may include a selected number *n* of delay components 204. In this example, an *N-th* delay component 204(n) may include a first input coupled to a node 210(n-1) to receive a delayed square wave 130(n-1), a second input coupled to the clock input 106 to receive the clock signal 132, and an output coupled to the node 210(n) to provide an *N-th* delayed square wave 130(n).

The HC sine-wave generator 102 may include a plurality of taps, including taps 206(0), a tap 206(1), ..., 206(n). The tap 206(0) may include a first input coupled to the input 104 to receive the square wave 110 and may include an output coupled to a node 212(0). The tap 206(1) may include a first input coupled to the first node 210(1) to receive the first delayed square wave 130(1) and may include an output coupled to the node 212(1). The HC sine-wave generator 102 may include a number *n* of taps 206. The tap 206(n) may include a first input coupled to the node 210(n) to receive the *n-th* delayed square wave 130(n) and may include an output coupled to the node 212(n).

The HC sine-wave generator 102 may include summing circuitry 128, which may include a plurality of summing nodes 214. In the illustrated example, the summing circuitry 128 may include a first summing node 214(1), one or more intermediate summing nodes 214 (not shown), and a N-th summing node 214(n). The first summing node 214(1) may include a first input coupled to the node 212(0) to receive an amplitude-scaled square wave (i.e., a weighted version of the square wave 110), a second input coupled to the node 210(1) to receive an amplitude-scaled square wave that is a weighted version of the first delayed square wave 130(1), and an output coupled to an output node 214(1), which may be configured to provide a first output signal to the output node 216(1). Each of the intermediate summing nodes (not shown) may include a first input coupled to the output node 216 of a previous summing node 214, a second input coupled to a node 212 to receive an amplitude-scaled square wave from one of the intermediate taps 206, and an output coupled to a corresponding output node 216. The N-th summing node 214(n) may include a first input coupled to the output node 216(n-1), a second input coupled to the node 212(n), and an output coupled to an output node 216(n), which may be coupled to the output terminal 108 to provide the output signal *y(t)*.

In one or more embodiments, the HC sine-wave generator 102 may include an FIR filter in which *k* may represent the number of notches (number of zeros) that are implemented and $f_0$ may represent the frequency of the input square wave 110. In such an embodiment, the HC sine-wave generator 102 may be configured to produce delayed square waves 130 that can be amplitude-scaled and combined with the amplitude-scaled square wave 110 to place notches or zeros at selected frequencies, such as selected (odd-order, even-order, or both) harmonic frequencies $f_1, f_2, ..., f_k$ of the frequency $f_0$ of the input square wave 110. In an example, the frequency $f_1$ may represent the second harmonic, the frequency $f_2$ may represent the third harmonic, the frequency $f_3$ may represent the fourth harmonic, ..., and the frequency $f_k$ may represent the *k+1-th* harmonic, which harmonics represent the frequencies at which notches are placed. With respect to the frequency $f_{clk}$ of the clock signal 132, normalized notch frequencies $f_1/f_{clk}, f_2/f_{clk}, ..., f_n/f_{clk}$ may be obtained, and a complex conjugate zero-pair may be placed at every harmonic at which energy is to be eliminated or suppressed. In one or more embodiments, the clock frequency $f_{clk}$ may be varied or changed to vary or change the location of the zeros. The frequency $f_0$ of the square wave 110 may be selected such that its harmonics coincide with or correspond to the notches implemented by the FIR filter. The relationship between the clock frequency $f_{clk}$, the frequency $f_0$ of the square wave 110, and the number of notches (zeros) *k* may correspond to the number of taps 206 and may be determined as follows:

$$f_{clk} = 2 \times (k + 1) \times f_0 \text{ . when } k \text{ is odd; and}$$

$$f_{clk} = 2 \times k \times f_0 \text{ when } k \text{ is even.} \quad (3)$$

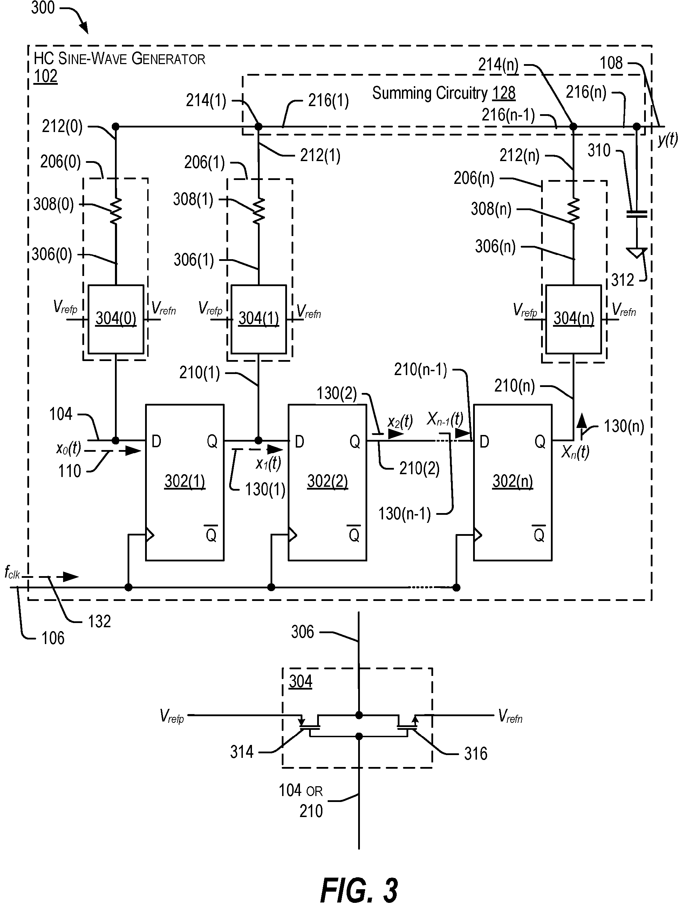

In one or more embodiments, the coefficients $b_0, b_1, ..., b_n$ of the taps 206 may be realized using or defined by resistors (such as resistors 308 in FIG. 3) having selected resistance $R_1, R_2, ..., R_n$ as one of the possible implementations. In one or more embodiments, the delay components 204 may be implemented as a J-K flip-flop circuit, a D flip-flop circuit, a D-latch circuit, a shift register, other edge-triggered logic circuits, or any combination thereof. An example of an embodiment of the circuit of FIG. 2 where the delay components 204 are implemented as D flip-flops and the taps 206 are implemented as tap resistors is described below with respect to FIG. 3.

FIG. 3 depicts a partial block diagram and partial circuit diagram of an embodiment of a semiconductor device 300 including a circuit implementation of the sine-wave generator 102 of FIG. 2 based on FIR notch filtering, in accordance with certain embodiments of the present disclosure. In the illustrated embodiment, the delay components 204 are implemented as D flip-flops 302 and each of the taps 206 is implemented by a resistor 308 including a first terminal coupled to the output node 212 and including a second terminal coupled to a switch circuit 304. In one or more embodiments, as shown below the HC sine-wave generator 102 in the figure, the switch circuit 304 may be implemented by pair of transistors including a p-channel metal oxide semiconductor (PMOS) 314 and an n-channel metal oxide semiconductor (NMOS) transistor 316. The PMOS 314 may include a source coupled to a first reference voltage $V_{refp}$, a gate coupled to the node 210 (or to the input 104 for the first switch circuit 304(0)), and a drain coupled to the node 306. The NMOS 316 may include a source coupled to a second reference voltage $V_{refn}$, a gate coupled to the node 210 (or to the input 104 for the first switch circuit 304(0)), and a drain coupled to the node 306.

In the illustrated embodiment, the HC sine-wave generator 102 may include a plurality of D flip-flops 302 including a first D flip-flop 302(1), a second D flip-flop 302(2), one or more intermediate D flip-flops 302 (not shown), and an N-th D flip-flop 302(n). The first D flip-flop 302(1) may include a data input *D* coupled to the input 104 to receive the square wave 110, a clock input coupled to the clock input 106 to receive the clock signal 132, and an output terminal *Q*, which is coupled to the node 210(1). The first D flip-flop 302(1) may be configured to provide a first delayed square wave 130(1) to the node 210(1). The first delayed square wave 130(1) may be a delayed version of the square wave 110 at the input 104.

The second D flip-flop 302(2) may include a data input *D* coupled to the node 210(1) to receive the first delayed square wave 130(1), a clock input coupled to the clock input 106 to receive the clock signal 132, and an output terminal *Q*,

which is coupled to the node 210(2). The second D flip-flop 302(2) may be configured to provide a second delayed square wave 130(2) to the node 210(2). The second delayed square wave 130(2) may be a delayed version of the first delayed square wave 130(1) at the node 210(1).

If the FIR filter includes more than three taps 206, then the FIR filter may include one or more intermediate D flip-flops 302 (not shown). Each intermediate D flip-flop 302 may include a data input $D$ coupled to the node 210 from the preceding D flip-flop 302 in the sequence to receive a delayed square wave 130, a clock input coupled to the clock input 106 to receive the clock signal 132, and an output terminal $Q$, which is coupled to a corresponding node 210 to provide a delayed square wave 130 at the output terminal $Q$.

The N-th D flip-flop 302(n) may include a data input $D$ coupled to the node 210(n-1) to receive the delayed square wave 130(n-1), a clock input coupled to the clock input 106 to receive the clock signal 132, and an output terminal $Q$, which is coupled to the node 210(n). The N-th D flip-flop 302(2) may be configured to provide an n-th delayed square wave 130(n) to the node 210(n). The n-th delayed square wave 130(n) may be a delayed version of the delayed square wave 130(n-1).

The plurality of taps 206(0), 206(1), ..., 206(n) may be coupled to the output nodes 212. Each tap 206 may include a resistor 308 including a first terminal coupled to the output node 212 and a second terminal coupled to a node 306. Each tap 206 may include a switch 304 coupled between the node 306 and either the input 104 (for the first tap 304(0)) or one of the nodes 210.

The first tap 206(0) may include a first switch 304(0) including an input terminal coupled to the input 104 to receive the square wave 110, a first supply terminal configured to receive a first supply voltage $V_{refp}$, a second supply terminal configured to receive a second supply voltage $V_{refn}$, and an output terminal coupled to the node 306(0). The first tap 206(0) may include a first resistor 308(0) coupled between the node 306(0) and the node 212(0).

The tap 206(1) may include a switch 304(1) including an input terminal coupled to the node 210(1) to receive the first delayed square wave 130(1), a first supply terminal configured to receive a first supply voltage $V_{refp}$, a second supply terminal configured to receive a second supply voltage $V_{refn}$, and an output terminal coupled to the node 306(1). The tap 206(1) may include a resistor 308(1) coupled between the node 306(1) and the node 212(1).

In one or more embodiments, if there are intermediate D flip-flops 302, there may be corresponding one or more intermediate taps 206, each of which may include a switch 304 coupled between one of the nodes 210 and a node 306 and a resistor 308 coupled between the node 306 and the node 212. In one or more embodiments, one or more of the coefficients of the filter may be zero.

The tap 206(n) may include a switch 304(n) including an input terminal coupled to the node 210(n) to receive the n-th delayed square wave 130(n), a first supply terminal configured to receive a first supply voltage $V_{refp}$, a second supply terminal configured to receive a second supply voltage $V_{refn}$, and an output terminal coupled to the node 306(n). The tap 206(n) may include a resistor 308(n) coupled between the node 306(n) and the node 212(n).

The HC sin-wave generator 102 may include summing circuitry 128, which may include multiple summing nodes 214. In the illustrated example, the summing node 214(1) may include a first input coupled to the node 212(0), a second input coupled to the node 212(1), and an output coupled to the node 216(1). The one or more intermediate summing nodes 214 may include an input coupled to a node 216 at the output of a previous summing node 214 to receive the sum, a second input coupled to a corresponding node 212 to receive an amplitude-scaled square wave corresponding to delayed square wave 130 from one of the nodes 210, and an output coupled to a next node 216.

The N-th summing node 214(n) may include an input coupled to a node 212(n-1) to receive the sum of the previous summing node 214(n-1), a second input coupled to a node 212(n) to receive an amplitude-scaled square wave corresponding to the n-th delayed square wave 130(n), and an output 216(n) coupled to the output terminal 108 to provide the output signal $y(t)$.

In one or more embodiments, the output impedance of the HC cancellation sinewave generator 102 may be constant because the resistors 308 remain coupled to the output 108, either switched to the first power supply $V_{refp}$ or the second power supply $V_{refn}$. Since the output impedance remains constant, a low-pass filter may be added at the output, such as the capacitor 310 coupled between the output node 216(n) and electrical ground. Higher-order harmonics that are not blocked by the notches of the FIR filter may be attenuated by the low-pass nature of the resistor-capacitor (RC) filter formed by the resistances presented by the resistors 308 and the capacitance presented by the capacitor 310.

In the illustrated example of FIG. 3, the square wave 110 and the delayed square waves 130(1), 130(2), ..., 130(n) may be amplitude-scaled by the taps 206(0), 206(1) ,..., 206(n). The resulting amplitude-scaled square waves (amplitude-scaled square wave 110 and amplitude-scaled delayed square waves 130) may be added together by the summing circuitry 128 to produce, at the output terminal 108, an output signal y(t) with suppressed energy at selected frequencies (such as odd-order harmonics and/or even-order harmonics of the frequency of the input square wave 110), enabling a selected tone.

In one or more embodiments, the HC sine-wave generator 102 described above with respect to FIGs. 1A-3 may be used to produce a single tone. In FIGs. 2 and 3, the embodiments of the HC sine-wave generator 102 are based on a FIR filter to provide a single tone. The tone may be used in a variety of operations, such as mixed-signal testing, bioimpedance measurements for cancer diagnosis, body composition analysis, electrochemical applications (such as lithium-battery evaluation, fuel-cell-condition monitoring, and protective coating evaluation), other operations, or any combination thereof.

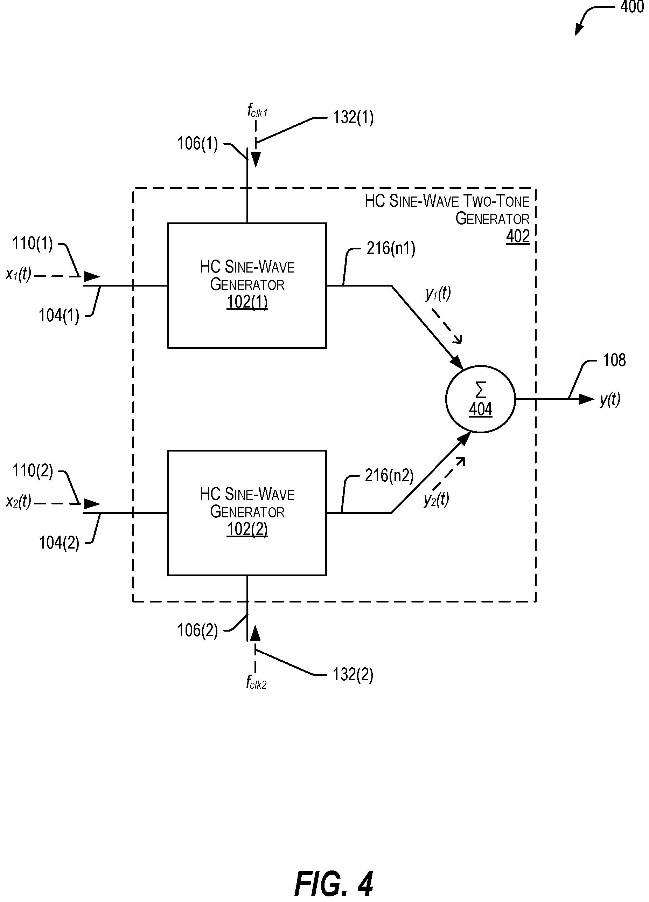

In other embodiments, the HC sine-wave generator 102 and the associated methods may be extended to provide a two-tone generator for two-tone testing. Dual tones may be used for measuring intermodulation distortion of a device under test, such as an analog-to-digital converter (ADC), which may be tested to characterize its linearity. In one or more embodiments, two tones may be generated by interconnecting two HC sine-wave generators 102 and linearly summing the outputs of the two HC sine-wave generators 102 as described below with respect to FIG. 4.

FIG. 4 depicts a block diagram of an embodiment of a two-tone generator 400 including two FIR filter-based HC sine-wave generators 102(1) and 102(2) configured to provide harmonic cancellation, in accordance with certain embodiments of the present disclosure. In one or more embodiments, the HC sine-wave two-tone generator 402 may include an input 104(1) to receive a first square wave 110(1), a second input 104(2) to receive a second square wave, a first clock input 106(1) to receive a first clock signal 132(2), and a second clock input 106(2) to receive a second clock signal 132(2).

The HC sine-wave two-tone generator 402 may include a first HC sine-wave generator 102(1) coupled to the first input 104(1) and to the first clock input 106(1) and including an output 216(n1) configured to provide a first output signal $y_1(t)$ including a first tone. The HC sine-wave two-tone generator 402 may include a second HC sine-wave generator 102(2) coupled to the second input 104(2) and to the second clock input 106(2) and including an output 216(n2) configured to provide a second output signal $y_2(t)$ including a second tone. The HC sine-wave two-tone generator 402 may include a summing node 404 including a first input coupled to the output 216(n1) of the first HC sine-wave generator 102(1) to receive the first output signal $y_1(t)$, a second input coupled to the output 216(n) of the second HC sinewave generator 102(2) to receive the second output signal $y_2(t)$, and an output coupled to the output 108 to provide an output signal $y(t)$ having two tones.

In one or more embodiments, the clock signals 132(1) and 132(2) have frequencies $f_{clk1}$ and $f_{clk2}$, which may be the same or different. In one or more embodiments, the set of coefficients for the taps 206 of the first HC sine-wave generator 102(1) (i.e., $b_0$, $b_1$, ... , $b_n$) may be the same or different from the set of coefficients for the taps 206 of the second HC sinewave generator 102(2) (i.e., $b'_0$, $b'_1$, ... , $b'_n$). For example, the resistances of resistors 308 may differ from one another. In one or more embodiments, the resistances of the resistors 308 of the HC sine-wave generator 102(1) may differ from the resistances of the resistors 308 of the HC sine-wave generator 102(2). In one or more embodiments, the clock frequencies $f_{clk1}$ and $f_{clk2}$ and the set of coefficients (resistances) corresponding to the two FIR filters can be designed in various ways.

In one or more embodiments, the clock frequencies $f_{clk1}$ and $f_{clk2}$ may be equal, and the set of coefficients (resistances of resistors 308) for the taps 206 of the first HC sine-wave generator 102(1) (i.e., $b_0$, $b_1$, ..., $b_n$) may be different from the set of coefficients (resistances of the resistors 308) for the taps 206 of the second HC sine-wave generator 102(2) (i.e., $b'_0$, $b'_1$, ... , $b'_n$). In one or more embodiments, the clock frequencies $f_{clk1}$ and $f_{clk2}$ may be different, and the set of coefficients (resistances) for the taps 206 of the first HC sine-wave generator 102(1) (i.e., $b_0$, $b_1$, ..., $b_n$) may be the same as the set of coefficients for the taps 206 of the second HC sine-wave generator 102(2) (i.e., $b'_0$, $b'_1$, ... , $b'_n$). In one or more embodiments, the clock frequencies $f_{clk1}$ and $f_{clk2}$ may be different, and the set of coefficients (resistances) for the taps 206 of the first HC sine-wave generator 102(1) (i.e., $b_0$, $b_1$, ..., $b_n$) may be different from the set of coefficients for the taps 206 of the second HC sine-wave generator 102(2) (i.e., $b'_0$, $b'_1$, ... , $b'_n$).

In the embodiment depicted in FIG. 4, only two HC sine-wave generators 102 are used to produce an HC sine-wave two-tone generator 402. It should be appreciated that, in one or more embodiments, an HC sine-wave $n$-tone generator may be produced by including $n$ HC sine-wave generators 102, each of which may produce one of the tones. As discussed above, the HC sine-wave generators 102 may receive clock signals that have clock frequencies that are the same or different, may have tap coefficients that are the same or different, or any combination thereof.

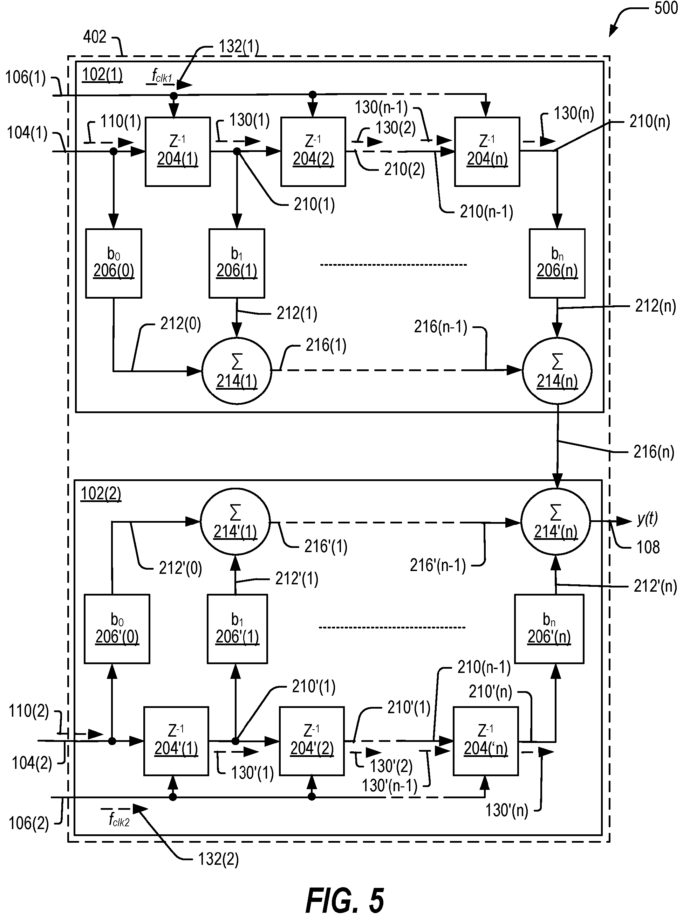

FIG. 5 depicts a block diagram 500 of an embodiment of the two-tone generator 400 of FIG. 4 including two FIR filters (two HC sine-wave generators 102) to provide harmonic cancellation, in accordance with certain embodiments of the present disclosure. The first HC sine-wave generator 102(1) may include all the elements of the HC sine-wave generators of FIGs. 2 and 3, except that the output of the summing node 214(n) is not connected to the output terminal 108. For clarity, the elements within the first and second HC sine-wave generators 102(1) and 102(2) are labeled with the same reference numbers as in FIG. 2, except that the reference numerals of the elements within the second HC sine-wave generator 102(2) include an apostrophe to differentiate.

In the illustrated embodiment, a first HC sine-wave generator 102(1) may include a first input 104(1) to receive a first square wave 110(1) and a first clock input 106(1) to receive a first clock signal 132(1) having a first frequency $f_{clk1}$. The first HC sine-wave generator 102(1) may include a plurality of delay components 204(1), 204(2), ..., 204(n), each of which includes a data input, a clock input, and an output terminal. The first HC sine-wave generator 102(1) may include a plurality of taps 206(0), 206(1), ..., 206(n), each of which may include an input and an output.

The first delay component 204(1) may include a data input coupled to the first input 104(1) to receive a first square wave 110(1), a clock input coupled to the first clock input 106(1) to receive a first clock signal 132(1), and an output coupled to a node 210(1) to provide a first delayed square wave 130(1). The second delay component 204(2) may include a data input coupled the node 210(1) to receive the delayed square wave 130(1), a clock input coupled to the first clock input 106(1) to receive the first clock signal 132(1), and an output coupled to a node 210(2). The HC sine-wave generator 102(1) may include one or more intermediate delay components 204 (not shown) between the second node 210(2) and a node 210(n-1), each of which may receive a delayed square wave 130 at a node 210 from a previous delay component 204 in the sequence and each of which may provide a further delayed square wave to the next node 210. The n-th delay component 204(n) may include a data input coupled to the node 210(n-1) to receive the delayed square wave 130(n-1), a clock input coupled to the first clock input 106(1) to receive the clock signal 132(1), and an output coupled to the node 210(n) to provide a delay square wave 130(n).

The first tap 206(0) may include an input coupled to the first input 104(1) to receive the first square wave 110(1) and an output coupled to a first node 212(0). The first tap 206(0) may be configured to provide an amplitude-scaled square wave based on the first square wave 110(1) to the first node 212(0). The second tap 206(1) may include an input coupled to the node 210(1) to receive a delayed square wave 130(1) and an output coupled to a second node 212(1) and may be configured to provide an amplitude-scaled square wave based on the delayed square wave 130(1) to the second node 212(1). The plurality of taps 206 may include one or more intermediate taps 206 (not shown), each of which may include an input coupled to one of the nodes 210 and an output coupled to one of the nodes 212 including a node 212(n-1), and each of which may be configured to generate an amplitude-scaled square wave of the delayed square wave 130 at its input and to provide the amplitude-scaled square wave to its output. The n-th tap 206(n) may include an input coupled to the node 210(n) and an output coupled to the node 212(n) and may be configured to generate an amplitude-scaled square wave based on the delayed square wave 130(n) to the node 212(n).

The first HC sine-wave generator 102(1) may include summing circuitry 128, which may include a plurality of summing nodes 214. A first summing node 214(1) may include a first input coupled to the node 212(0), a second input coupled to the node 212(1), an output coupled to the output node 216(1). The first HC sine-wave generator 102(1) may include one or more intermediate summing nodes 214 (not shown) between the summing node 214(1) and the output node 216(n-1), each of which may include a first input coupled to one of the output nodes 216, a second node coupled to one of the nodes 212, and an output coupled to a next output node 216.

The first HC sine-wave generator 102(1) may include a summing node 214(n) that includes a first input coupled to an output node 216(n-1), a second input coupled to the node 212(n), and an output coupled to an output node 216(n), which may be coupled to a summing node 214'(n) of the second HC sine-wave generator 102(2).

The second HC sine-wave generator 102(2) may include a second input 104(2) to receive a second square wave 110(2) and a second clock input 106(2) to receive a second clock signal 132(2) having a second frequency $f_{clk2}$. The second HC sine-wave generator 102(2) may include a plurality of delay components 204'(1), 204'(2), ..., 204'(n), each of which includes a data input, a clock input, and an output terminal. The second HC sine-wave generator 102(2) may include a plurality of taps 206'(0), 206'(1), ..., 206'(n), each of which may include an input and an output.

The first delay component 204'(1) may include a data input coupled to the second input 104(2) to receive a second square wave 110(2), a clock input coupled to the second clock input 106(2) to receive a second clock signal 132(2), and an output coupled to a node 210'(1) to provide a first delayed square wave 130'(1). The second delay component 204'(2) may include a data input coupled the node 210'(1) to receive the delayed square wave 130'(1), a clock input coupled to the second clock input 106(2) to receive the second clock signal 132(2), and an output coupled to a node 210'(2). The HC sine-wave generator 102(2) may include one or more intermediate delay components 204' (not shown) between the second node 210'(2) and a node 210'(n-1), each of which may receive a delayed square wave 130' at a node 210' from a previous delay component 204' in the sequence and each of which may provide a further delayed square wave to the next node 210'. The n-th delay component 204'(n) may include a data input coupled to the node 210'(n-1) to receive the delayed square wave 130'(n-1), a clock input coupled to the second clock input 106(2) to receive the clock signal 132'(1), and an output coupled to the node 210'(n) to provide a delay square wave 130'(n).

The first tap 206'(0) may include an input coupled to the second input 104(2) to receive the second square wave 110(2) and an output coupled to a first node 212'(0). The first tap 206'(0) may be configured to provide an amplitude-scaled square wave based on the second square wave 110(2) to the first node 212'(0). The second tap 206'(1) may include an input coupled to the node 210'(1) to receive a delayed square wave 130'(1) and an output coupled to a second node 212'(1) and may be configured to provide an amplitude-scaled square wave based on the delayed square wave 130'(1) to the second node 212'(1). The plurality of taps 206' may include one or more intermediate taps 206' (not shown), each of which may include an input coupled to one of the nodes 210' and an output coupled to one of the nodes 212' including a node 212'(n-1), and each of which may be configured to receive a delayed square wave 130' from the node 210' and to provide an amplitude-scaled square wave based on the delayed square wave 130' to the node 212'. The n-th tap 206'(n) may include an input coupled to the node 210'(n) and an output coupled to the node 212'(n) and may be configured to provide an amplitude-scaled square wave based on the delayed square wave 130'(n) to the node 212'(n).

The second HC sine-wave generator 102(2) may include summing circuitry 128', which may include a plurality of summing nodes 214'. A first summing node 214'(1) may include a first input coupled to the node 212'(0), a second input coupled to the node 212'(1), and an output coupled to the node 216'(1). The second HC sine-wave generator 102(2) may include one or more intermediate summing nodes 214' (not shown) between the summing node 214'(1) and the output node 216'(n-1), each of which may include a first input coupled to one of the output nodes 216', a second node coupled to one of the nodes 212', and an output coupled to a next output node 216'. The n-th summing node 214'(n) may include a first input coupled to the node 216'(n-1), a second input coupled to the node 212'(n), a third input coupled the node 216(n), and an output coupled to the output terminal 216(n), which may be coupled to the output terminal 108 to provide the output signal $y(t)$ including two distinct fundamental tones.

It should be appreciated that each of the HC sine-wave generators 102(1) and 102(2) produces an output signal that has a single fundamental tone. The output signals may be combined by the summing node 214'(n) to produce the output signal $y(t)$ including both fundamental tones and with suppressed energy at selected harmonics of the fundamental tones.

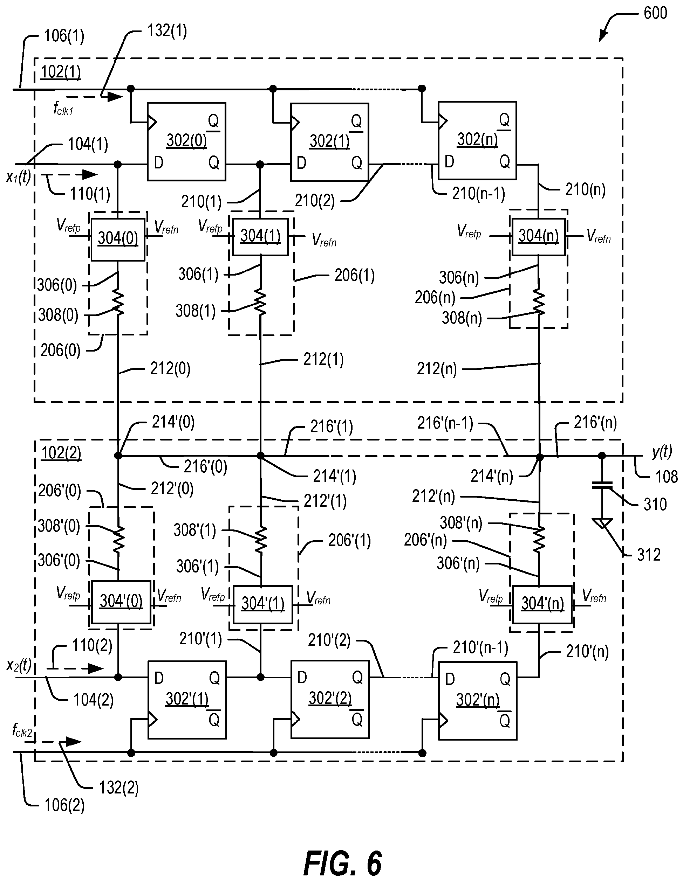

In one or more embodiments, the delay components 204 may be implemented as D flip-flops and the taps 206 may be represented by switched resistances. In one or more embodiments, a capacitor may be included at the output for further attenuation of highfrequency harmonics. An embodiment of the two-tone sine-wave generator 402 is described below with respect to FIG. 6 that includes D flip-flops 302, an output capacitor 310, and taps 206 represented by switched resistances.

FIG. 6 depicts a partial block diagram and partial circuit diagram of an embodiment of a system 600 including the two-tone generator 402 of FIGs. 4 and 5 based on FIR notch filtering including a passive resistor-capacitor (RC) filter at the output, in accordance with certain embodiments of the present disclosure. In the illustrated embodiment, the two-tone generator 402 may include two HC sine-wave generators 102(1) and 102(2), each of which may be an embodiment of the HC sine-wave generator 102 of FIG. 3. In this example, the nodes 212(0), 212(1), ..., 212(n) of the first HC sine-wave generator 102(1) are coupled to the summing nodes 214' of the second HC sine-wave generator 102(2). The summing node 214'(n) may combine the output signal from the first HC sine-wave generator 102(1) with the output of the second HC sine-wave generator 102(2) to provide a combined signal to the output node 216'(n). Alternatively, as depicted in FIG. 4, an additional summing node 214 may be included that may have a first input coupled to the node 216(n1) from the first HC sine-wave generator 102(1), a second input coupled to the node 216(n2) from the second HC sine-wave generator 102(2), and an output coupled to the output terminal 108. It should be appreciated that, while the summing nodes 214 are depicted as if they were components, in one or more embodiments, the summing nodes 214 may be electrical interconnection points where currents from the taps 206 are added, such that the summing operation is performed everywhere along the nodes 216.

In one or more embodiments, the first HC sine-wave generator 102(1) may include all the elements of the HC sine-wave generator 102 of FIG. 3, except the summing circuitry 128, including the summing nodes 214(1), ..., 214(n), the output nodes 216(1),..., 216(n), and the capacitor 310 may be omitted. In one or more embodiments, the summing circuitry 128 of the second HC sine-wave generator 102(2) may perform the summing operations for both the first and second HC sine-wave generators 102(1) and 102(2) and may include the capacitor 310 coupled to the output node 216'(n). For clarity, the elements within the first and second HC sine-wave generators 102(1) and 102(2) are labeled with the same reference numbers as in FIG. 3, except that the reference numerals of the elements within the second HC sine-wave generator 102(2) include an apostrophe to differentiate.

The summing node 214'(0) may include a first input coupled to the node 212(0) from the first HC sine-wave generator 102(1), a second input coupled to the node 212'(0) from the second HC sine-wave generator 102(2), and an output coupled to an output node 216'(0). In the illustrated embodiment, the summing node 214'(1) may include a first input coupled to the output node 216'(0), a second input coupled to the node 212'(1) of the second HC sinewave generator 102(2), and an output coupled to the output node 216'(1). One or more intermediate summing nodes 214' (not shown) may include a first input coupled to an output node 216', a second input coupled to a node 212', and an output coupled to a next output node 216'. The n-th summing node 214'(n) may include a first input coupled to the output node 216(n-1), a second input coupled to the node 212(n) from the first HC sine-wave generator 102(1), a third input coupled to the node 212'(n), and an output coupled to the output node 216'(n). The second HC sine-wave generator 102(2) may include or may be coupled to a capacitor 310 including a first terminal coupled to the output node 216'(n) and a second terminal coupled to ground 312. The output node 216'(n) may be coupled to the output terminal 108 to provide the output signal $y(t)$ including two distinct tones and suppressed energy at selected harmonics of the frequencies of the tones.

In the illustrated embodiment, the delay components 204 and 204' are implemented as D flip-flops 302 and 302' and each of the taps 206 and 206' is implemented by a resistor 308 or 308' including a first terminal coupled to the output node 212 or 212' and including a second terminal coupled to a switch circuit 304 or 304'. Each switch circuit 304 or 304' may be implemented by pair of transistors including a p-channel metal oxide semiconductor (PMOS) 314 or 314' and an n-channel metal oxide semiconductor (NMOS) transistor 316 or 316'. The PMOS and NMOS transistor implementation of the switches 304 and 304' may be understood from the example depicted in FIG. 3 and is not recreated here.

In one or more embodiments, the clock signals 132(1) and 132(2) have frequencies $f_{clk1}$ and $f_{clk2}$, which may be the same or different. In one or more embodiments, the set of coefficients for the taps 206 of the first HC sine-wave generator 102(1) (i.e., $b_0$, $b_4$, ..., $b_n$) may be the same or different from the set of coefficients for the taps 206 of the second HC sinewave generator 102(2) (i.e., $b'_0$, $b'_1$, ... , $b'_n$). Thus, the clock frequencies $f_{clk1}$ and $f_{clk2}$ and the set of coefficients (resistances) corresponding to the two FIR filters can be designed in various ways.

In one or more embodiments, the clock frequencies $f_{clk1}$ and $f_{clk2}$ may be equal, and the set of coefficients (resistances) for the taps 206 of the first HC sine-wave generator 102(1) (i.e., $b_0$, $b_1$, ..., $b_n$) may be different from the set of coefficients for the taps 206 of the second HC sine-wave generator 102(2) (i.e., $b'_0$, $b'_1$, ..., $b'_n$). In other words, the resistances of the resistors 308(0), 308(1), ..., 308(n) may be different from the resistances of the resistors 308'(0), 308'(1), ..., 308'(n). In one or more embodiments, the clock frequencies $f_{clk1}$ and $f_{clk2}$ may be different, and the set of coefficients (resistances) for the taps 206 of the first HC sinewave generator 102(1) (i.e., $b_0$, $b_1$, ... , $b_n$) may be the same as the set of coefficients for the taps 206 of the second HC sine-wave generator 102(2) (i.e., $b'_0$, $b'_1$, ..., $b'_n$). In one or more embodiments, the clock frequencies $f_{clk1}$ and $f_{clk2}$ may be different, and the set of coefficients (resistances) for the taps 206 of the first HC sine-wave generator 102(1) (i.e., $b_0$, $b_1$, ..., $b_n$) may be different from the set of coefficients for the taps 206 of the second HC sine-wave generator 102(2) (i.e., $b'_0$, $b'_1$, ..., $b'_n$).

In one or more embodiments, the output impedance of the two-tone HC cancellation sine-wave generator 402 may be constant because the resistors 308 and 308' remain coupled to the output 108, either switched to the first power supply $V_{refp}$ or the second power supply $V_{refn}$. Since the output impedance remains constant, a low-pass filter may be added at the output, such as the capacitor 310 coupled between the output node 216'(n) and electrical ground. Higher-order harmonics that are not blocked by the notches at selected frequencies that are provided by the HC sine-wave generators 102(1) and 102(2) may be attenuated by the low-pass nature of the resistor-capacitor (RC) filter formed by the resistances presented by the resistors 308 and the capacitance presented by the capacitor 310.

In the following discussion, the harmonic interference produced by the square wave and the harmonic cancellation provided by the delayed and amplitude-scaled square waves produced by the HC sine-wave generator 102 are discussed.

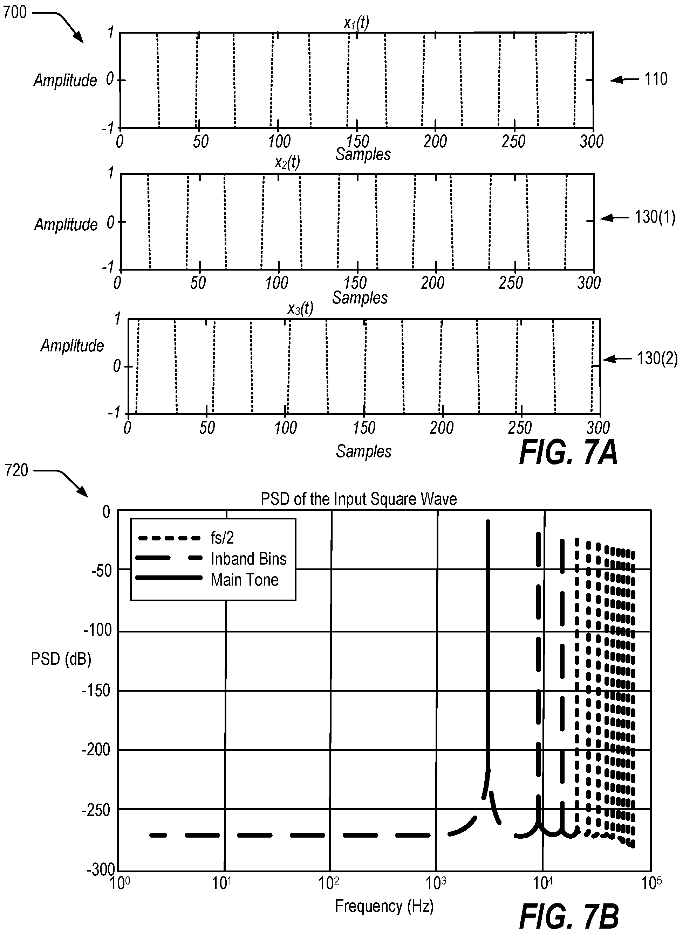

FIG. 7A depicts a graph 700 of amplitude versus samples of an input square wave 110 and a set of delayed square waves 130 in a time domain, in accordance with certain embodiments of the present disclosure. The graph 700 includes the input square wave 110, a first delayed square wave 130(1), and a second delayed square wave 130(2). Each square wave 110 and 130 has a period $T_0$ and an amplitude between zero and a supply voltage.

In the illustrated embodiment, the input square wave 110 may have a frequency (period) of approximately three kilohertz (3 kHz), and the clock frequency may be approximately one hundred forty-four kilohertz (144 kHz). The delayed square waves 130(1) and 130(2) have a phase difference of one-eighth of the period (i.,. $T_0/8$, which is approximately $\pi/4$ or 45 degrees) with respect to the input square wave 110.

FIG. 7B depicts a graph 720 of the output spectrum (amplitude in decibel units of voltage versus frequency in Hertz showing the power spectral density (PSD) of an input square wave, in accordance with certain embodiments of the present disclosure. In the illustrated example, the input square wave 110 produces a power spectral density that includes a tone at the fundamental frequency (3 kHz) and at selected harmonics of the fundamental frequency. The power spectral density components corresponding to fs/2 are outside of the bandwidth.

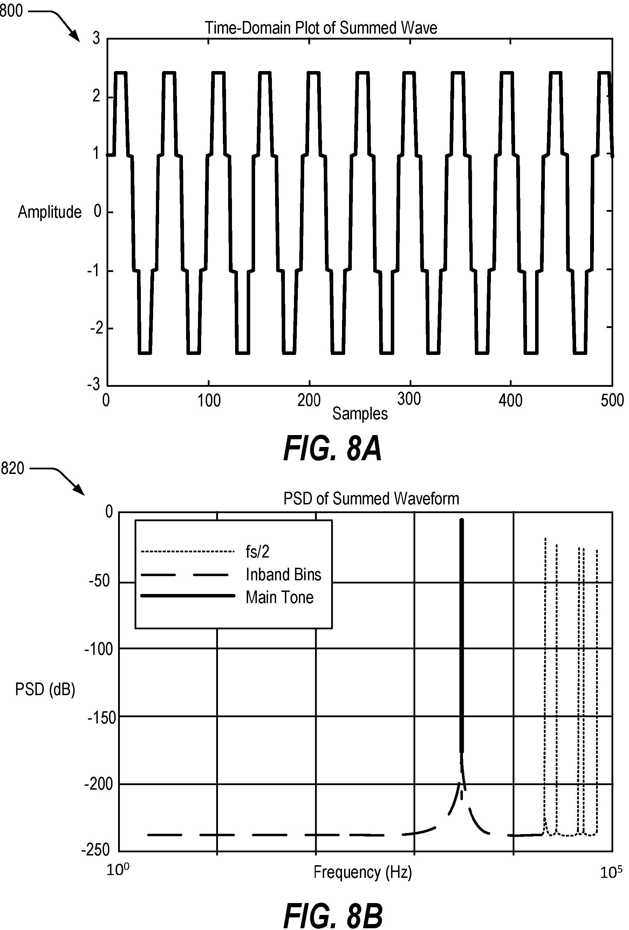

FIG. 8A depicts a graph 800 of amplitude versus sample number of the summed square waves 110, 130(1), and 130(2) of FIG. 7A in the time domain, in accordance with certain embodiments of the present disclosure. The graph shows that the amplitude of the summed square waves 110, 130(1), and 130(2) may be within a range of minus two point five (-2.5) to plus two point five (+2.5), which may be measured in millivolts, volts, or other units, depending on the implementation.

FIG. 8B depicts a graph 820 of the power spectral density (PSD) in decibels versus frequency in Hertz, in the frequency domain, for the summed waveform of FIG. 8A, in accordance with certain embodiments of the present disclosure. Comparing the graph 820 to the graph 720 of FIG. 7B, it can be observed that the tones at the third and fifth odd-order harmonics are eliminated. Even order notches may also be placed to eliminate even-order distortion.

In one or more embodiments, notches or zeros may be placed at additional selected harmonics to further reduce harmonic distortion. In one or more embodiments, notches or zeros may also be placed at even-order harmonics (second, fourth, sixth, ...) to reduce or eliminate (suppress) even-order harmonics depending on the application. In some embodiments, each tap 206 may correspond to a notch, and the number of taps 206 may correspond to the number of notches.

In one or more embodiments, multiple notches may be placed at selected frequencies that correspond to selected harmonics. The filter response of the HC sine-wave generator 102 having such a configuration is described below with respect to FIGs. 8A and 8B.

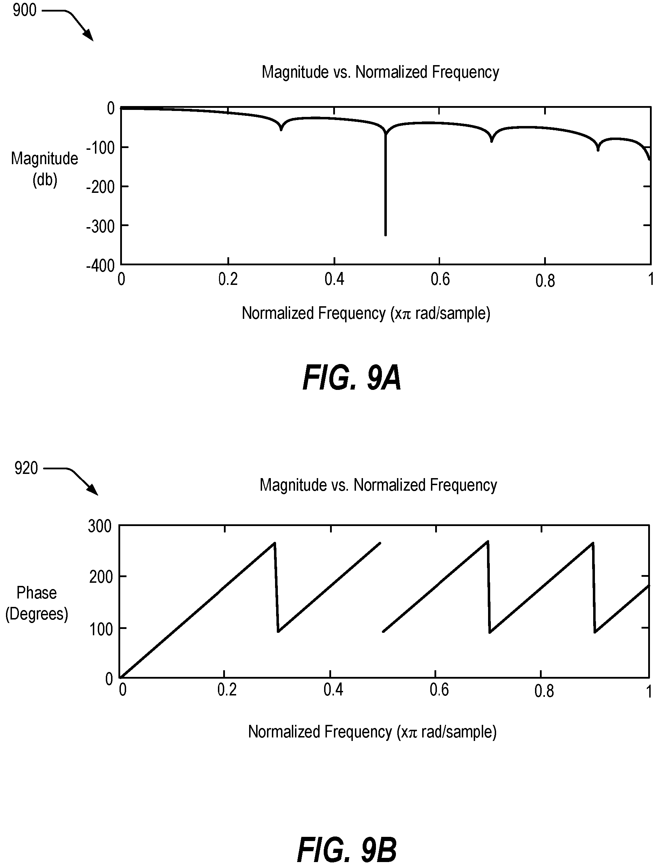

FIG. 9A depicts a graph 900 of the magnitude (dB) versus normalized frequency for an FIR filter with five notches at the third, fifth, seventh, and ninth harmonics and at half the clock frequency ($f_{clk}/2$), in accordance with certain embodiments of the present disclosure. In this example, the transfer function of the filter provided by the HC sine-wave generator 102 may include eleven coefficients corresponding to five zeros or notches (two x number of zeros + one). In the graph 900, the x-axis is normalized to half of the clock frequency ($f_{clk}/2$).

The graph 900 depicts five notches or zeros. Four of the notches correspond to the third, fifth, seventh, and ninth order harmonics. The fifth notch or zero corresponds to half the clock frequency. In one or more embodiments, notches may be placed at selected harmonics (even, odd, or both) of the frequency of the input square wave 110.

FIG. 9B depicts a graph 920 of the phase (in degrees) versus normalized frequency ($f_{clk}$/2) for an FIR filter with five notches at the third, fifth, seventh, and ninth harmonics and at half the clock frequency, in accordance with certain embodiments of the present disclosure. The graph 920 depicts a sawtooth waveform with a discontinuity at the midpoint of the clock frequency ($f_{clk}$/2).

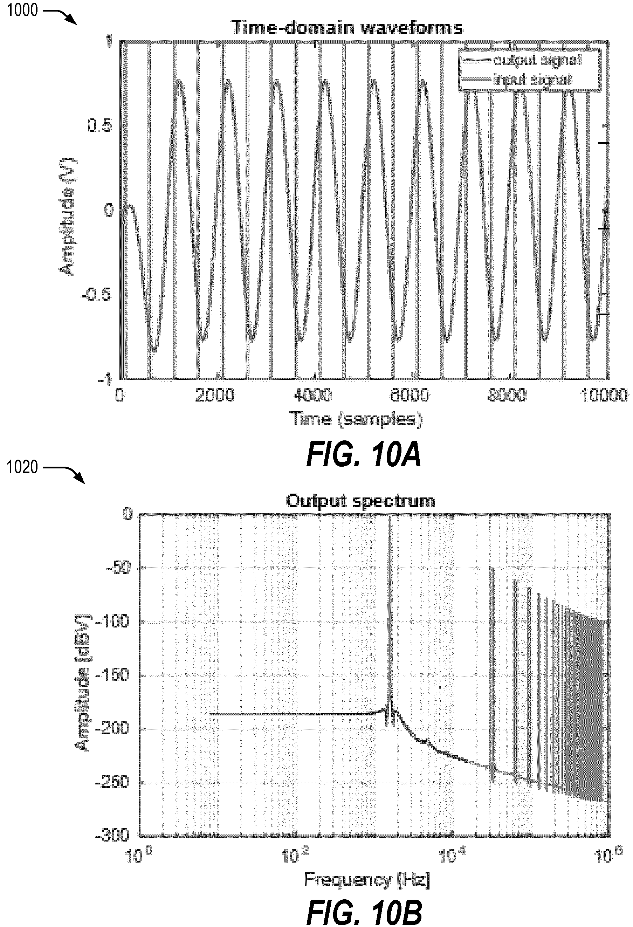

FIG. 10A depicts a graph of the amplitude (in volts) versus time (samples) for the HC sine-wave generator 102 depicting the input square wave 110 and the output signal $y(t)$, in accordance with certain embodiments of the present disclosure. In this example, the input frequency of the square wave 110 is one point six kilohertz (1.6 kHz). The input square wave 110 has an amplitude of plus or minus one volt, and the output sine wave $y(t)$ has an amplitude of plus or minus 0.75 volts with suppressed energy at selected harmonics of the frequency of the input square wave 110.

FIG. 10B depicts a graph of the power spectral density (amplitude (in decibel units of voltage) versus frequency (in Hertz)) in the frequency domain for the input signal and the output signal of FIG. 10A received and produced, respectively, by the HC sine-wave generator 102 including an FIR notch filter, in accordance with certain embodiments of the present disclosure. In the illustrated example, the HC sine-wave generator 102 includes notches at the third, fifth, seventh, and ninth odd-order harmonics, and at a frequency corresponding to half of the clock frequency ($f_{clk}$/2), resulting in elimination of tones at those frequencies. It should be understood that the HC sine-wave generator 102 may be configured to include notches at selected harmonics (odd, even, or both) of the frequency of the input square wave 110.

In this example, the input frequency of the square wave 110 is 1.6 kHz. The clock frequency $f_{clk}$ is approximately 32 kHz. In the illustrated embodiment, the cut-off frequency of the low-pass RC filter is at 2 kHz, where the output impedance is approximately one megaohm (1 MΩ), and the capacitor 310 is approximately fifty-three picofarads (53 pF). A roll-off of twenty decibels per decade (20 dB/decade) may be seen at frequencies above 2 kHz. Thus, the HC sine-wave generator 102 may be configured to provide complete harmonic cancellation with high-precision of the coefficient values.

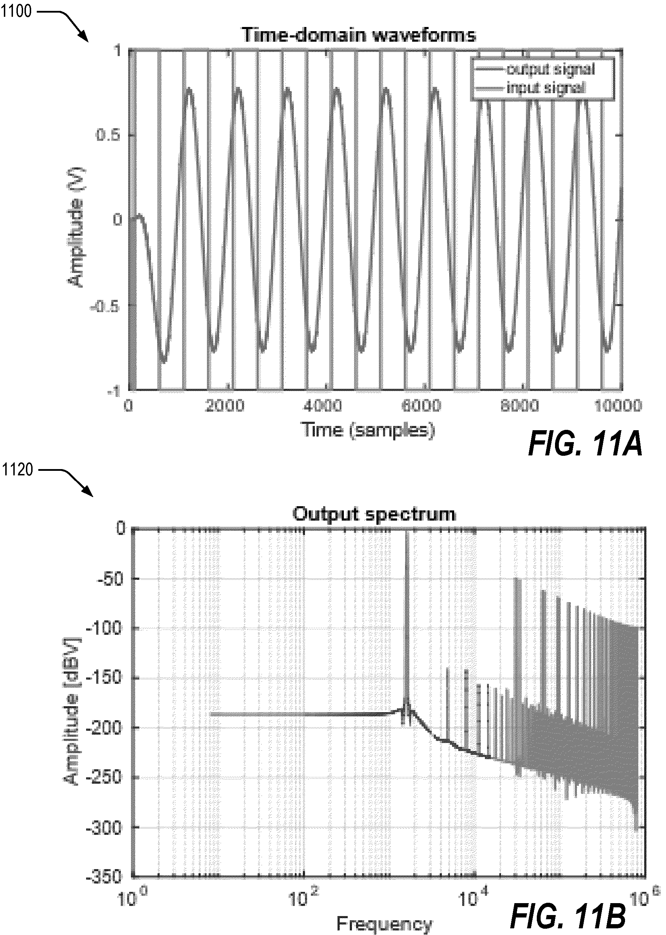

In the following discussion of FIGs. 11A and 11B, an input square wave 110 is provided to an HC sine-wave generator 102 having 11 taps with various resistance values, and the HC sine-wave generator 102 produces an output signal y(t) having suppressed harmonics.

FIG. 11A depicts a graph 1100 of the amplitude (in volts) versus time (samples) for the input square wave 110 and output signal $y(t)$ (sine wave) in the time domain, in accordance with certain embodiments of the present disclosure. In this example, the input square wave 110 may be received at the input 104 and the output signal may be determined at the output terminal 108.

In this illustrative, non-limiting example, the HC sine wave generator 102 may receive a square wave 110 having an input frequency $f_{in}$ equal to 1.6 kHz, and may receive a clock signal 132 having a clock frequency, $f_{clk}$ equal to 32 kHz. The total harmonic distortion may be -138 dB for a frequency bandwidth $f_b$ of 15.2 kHz. In this example, the HC sine wave generator 102 may include eleven taps 206 having resistance values as follows:

$$R_1 = R_{11} = 81726 \text{ k}\Omega$$

$$R_2 = R_{10} = 20944 \text{ k}\Omega$$

$$R_3 = R_9 = 11010 \text{ k}\Omega$$

$$R_4 = R_8 = 79997 \text{ k}\Omega$$

$$R_5 = R_7 = 6805 \text{ k}\Omega$$

$$R_6 = 6472 \text{ k}\Omega$$

In this example embodiment, the taps 206 may provide an output resistance of approximately one megaohm (1 MΩ).

FIG. 11B depicts a graph 1120 of the power spectral density (amplitude (in decibel units of voltage) versus frequency (in kilohertz)) for the HC sine-wave generator 102 of FIG. 11A, in accordance with certain embodiments of the present disclosure. The graph 1120 shows the impact of rounding of coefficients (up to four decimal places). As compared to the example of FIG. 10B, some harmonics are still present, though they are suppressed.

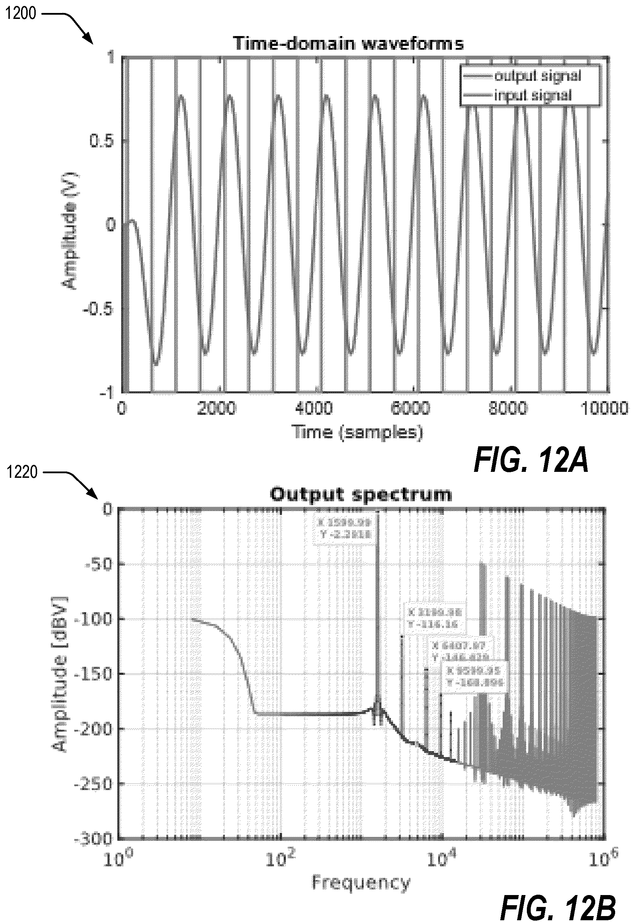

In some embodiments, the PMOS transistors 314 and NMOS transistors 316 in FIG. 3, which are present in the switches 304 in FIGs. 3 and 6, may present mismatched switch resistances. In the discussion of FIGs. 12A and 12B below, the input square wave 110 is presented to an embodiment of the HC sine-wave generator 102 that has mismatched switch resistances, and the HC sine-wave generator 102 produces the output signal *y(t)* with suppression of selected harmonics.

FIG. 12A depicts a graph 1200 of the amplitude (in volts) versus time (samples) for the input square wave 110 and the output signal *y(t)* in the time domain for a system having a mismatch between p-channel metal oxide semiconductor (PMOS) and n-channel (NMOS) switch resistances, in accordance with certain embodiments of the present disclosure.

In this example embodiment, the HC sine-wave generator 102 includes an input 104 to receive the input square wave 110 having an input frequency $f_{in}$ of 1.6 kHz. The HC sinewave generator 102 includes a clock input 106 configured to receive a clock signal 132 having a clock frequency $f_{clk}$ equal to 32 kHz. The total harmonic distortion is approximately -113 dB for a frequency bandwidth $f_b$ of 15.2 kHz, assuming the same set of tap resistance values as above in FIGs. 11A and 11B (rounded to 4 decimal places). The nominal value of the resistances of the PMOS transistors 314 and NMOS transistors is 200 Ohms. A worst-case mismatch is assumed to be 30% between the switch ON resistances of the PMOS transistors 314 and the NMOS transistors 316, and the power spectral density graph 1220 in FIG. 12B includes even-order distortion.

FIG. 12B depicts a graph 1220 of the power spectral density (amplitude (in decibel units of voltage) versus frequency (in kilohertz)) for an FIR notch filter output in the frequency domain or the system of FIG. 12A, in accordance with certain embodiments of the present disclosure. In this example, the HC sine-wave generator 102 produced an output signal y(t) including a fundamental tone and some harmonics, which are suppressed. Thus, the mismatched resistances may introduce some harmonic distortion, but the FIR filter components suppress the amplitude of the harmonics.

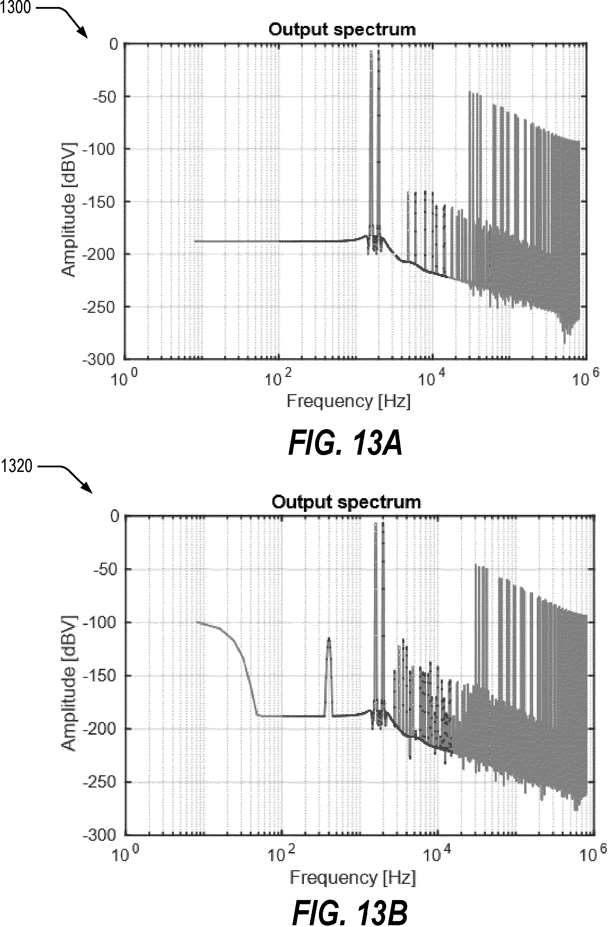

In FIGs. 13A-14B, the power spectral densities are shown for various configurations and clock frequencies for two-tone embodiments that includes a pair of HC sinewave generators 102(1) and 102(2). In FIG. 13A, a graph 1300 of the power spectral density of the output signal *y(t)* is shown that includes two tones. In the illustrated example, the HC sine-wave generators 102 may each include a plurality of taps 206, and the resistances of the resistors 308 may be equal, but the clock frequencies $f_{clk1}$ and $f_{clk2}$ of the clock signals 132(1) and 132(2) may be different. The switch resistances of the switches 304 (i.e., the PMOS transistors 314 and the NMOS transistors 316) are equal.

The two-tone HC sine-wave generator 402 may produce a first tone at 1.6 kHz and a second tone at 2 kHz using a first sine wave 110(1) having a frequency of 1.6 kHz and a second sine wave 110(2) having a frequency of 2 kHz. The first clock signal 132(1) may have a clock frequency $f_{clk1}$ of 32 kHz, and the second clock signal 132(2) may have a clock frequency $f_{clk2}$. The graph 1300 shows limited suppression of the selected harmonics, which is due to the rounding the coefficients. In the graph 1300, the third harmonic the frequencies of the first tone and the second tone can be seen at 4.8 kHz and 6 kHz, respectively. Similarly, limited suppression of the fifth, seventh, and ninth harmonics of the first and second tone can also be seen.

It should be appreciated that mismatches between the switch resistances may introduce harmonic interference. The power spectral density of an embodiment of a two-tone sine-wave generator 402 that includes a pair of HC sine-wave generators 102 with mismatched switch resistances is described below with respect to FIG. 13B.

FIG. 13B depicts a graph 1320 of the power spectral density (amplitude versus frequency in the frequency domain) of the output signal *y(t)* for an embodiment of a two-tone generator 402 that includes a mismatch in resistances between the PMOS and NMOS switches, in accordance with certain embodiments of the present disclosure. The nominal value of the switch resistances of the switches 304 is two hundred ohms (200 Ω). A worst-case assumption of the mismatch is thirty percent (30%) between the on-resistances of the PMOS transistors 314 and the NMOS transistors 316.

As in FIG. 13A, the two tones are generated at 1.6 kHz and 2 kHz using a first clock signal 132(1) having a first clock frequency of 32 kHz and a second clock signal 132(2) having a second clock frequency of 40 kHz. The intermodulation (IM2) distortion given by the difference between the second tone and the first tone at four hundred Hertz (400 Hz) and the sum of the first tone and the second tone at 3.6 kHz is visible in the graph 1320 in FIG. 13B.

In this example, the cut-off frequency of the low-pass RC filter is at 3 kHz, with an output impedance of one megaohm (1 MΩ) and an output capacitor 310 having a capacitance of fifty-three picofarads (53 pF). At frequencies above two kilohertz (2 kHz), the output power spectrum displays a roll-off of approximately twenty decibels per decade (20 dB/decade).

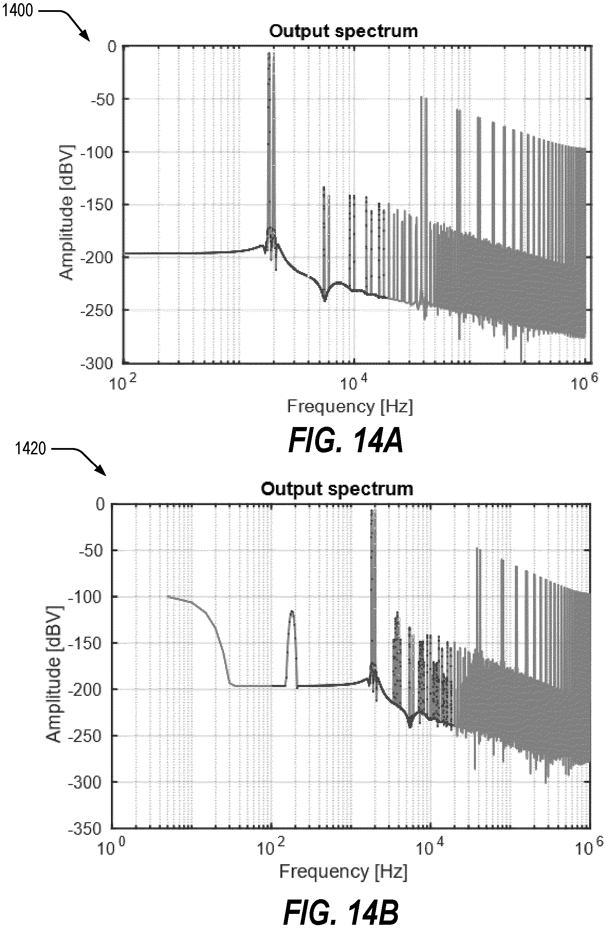

While the graphs 1300 and 1320 of FIGs. 13A and 13B depict the power spectral output for a two-tone sine-wave generator 402 with the same tap resistances and different clock frequencies, in one or more embodiments, the clock frequencies may be equal and the tap resistances may be different. Examples of the resulting power spectral densities are described below with respect to FIGs. 14A and 14B.

FIG. 14A depicts a graph 1400 of the power spectral density (amplitude versus frequency) in the frequency domain for another embodiment of a two-tone generator output with matched PMOS and NMOS resistances, in accordance with certain embodiments of the present disclosure. In this embodiment, the two-tone sine-wave generator 402 may include two different sets of tap resistances and may receive clock signals 132(1) and 132(2) having the same clock frequency of approximately 40 kHz. The two-tone sine-wave generator 402 may be configured to generate an output signal y(t) at the output terminal 108 that has two tones, including a first tone at a first frequency ($f_1$=1.818 kHz) and a second tone at a second frequency ($f_2$=2 kHz). In this example, the coefficient values and the resistance values for the first HC sine-wave generator 102(1) having eleven taps 206 are provided in Table 1 below.

Table 1. Coefficient values and resistance values for the HC sine-wave generator 102(1) having eleven taps 206.

| Coefficient (set 1) | Coefficient value | Resistance | Value of resistance (k$\Omega$) |
|---|---|---|---|
| $b_0$ (=$b_{10}$) | 1 | $R_1$ (=$R_{11}$) | 81726 |
| $b_1$ (=$b_9$) | 3.901 | $R_2$ (=$R_{10}$) | 20944 |
| $b_2$ (=$b_8$) | 7.4223 | $R_3$ (=$R_9$) | 11010 |
| $b_3$ (=$b_7$) | 10.2159 | $R_4$ (=$R_8$) | 79997 |
| $b_4$ (=$b_6$) | 12.0095 | $R_5$ (=$R_7$) | 6805 |
| $b_5$ | 12.6275 | $R_6$ | 6472 |

The coefficient values and the resistance values for the second HC sine-wave generator 102(2) having eleven taps 206 are provided in Table 2 below.

Table 2. Coefficient values and resistance values for the HC sine-wave generator 102(2) having eleven taps 206.

| Coefficient (set 2) | Coefficient value | Resistance | Value of resistance (k$\Omega$) |
|---|---|---|---|
| $b'_0$ (=$b'_{10}$) | 1 | $Rp_1$ (=$Rp_{11}$) | 49371 |
| $b'_1$ (=$b'_9$) | 2.919 | $Rp_2$ (=$Rp_{10}$) | 16913 |
| $b'_2$ (=$b'_8$) | 4.6015 | $Rp_3$ (=$Rp_9$) | 10729 |
| $b'_3$ (=$b'_7$) | 5.9112 | $Rp_4$ (=$Rp_8$) | 8352 |
| $b'_4$ (=$b'_6$) | 6.742 | $Rp_5$ (=$Rp_7$) | 7322 |
| $b'_5$ | 7.0267 | $Rp_6$ | 7026 |

In the graph 1400, the resistances of the switches 304 (PMOS transistors 314 and NMOS transistors 316) are assumed to be matched, which represents an ideal configuration. In this example, the output signal $y(t)$ at the output terminal 108 of the two-tone sine-wave generator 402 may include two distinct tones at 1.818 kHz and 2 kHz, and selected harmonics are suppressed. In this example, some harmonics are still present, which may be due to rounding of the coefficients.

FIG. 14B depicts a graph 1420 of the power spectral density (amplitude versus frequency) in the frequency domain for the configuration of FIG. 14A with mismatched PMOS and NMOS resistances, in accordance with certain embodiments of the present disclosure. In this example, the mismatched switch resistances provided by the PMOS transistors 314 and the NMOS transistors 316 of the switches 304 may introduce intermodulation (IM2) distortion at 182 Hz for the difference between the tone frequencies ($f_2$-$f_1$) and a 3.818 kHz for the sum of the tone frequencies ($f_2$+$f_1$). The IM2 distortion is visible in the graph 1420.

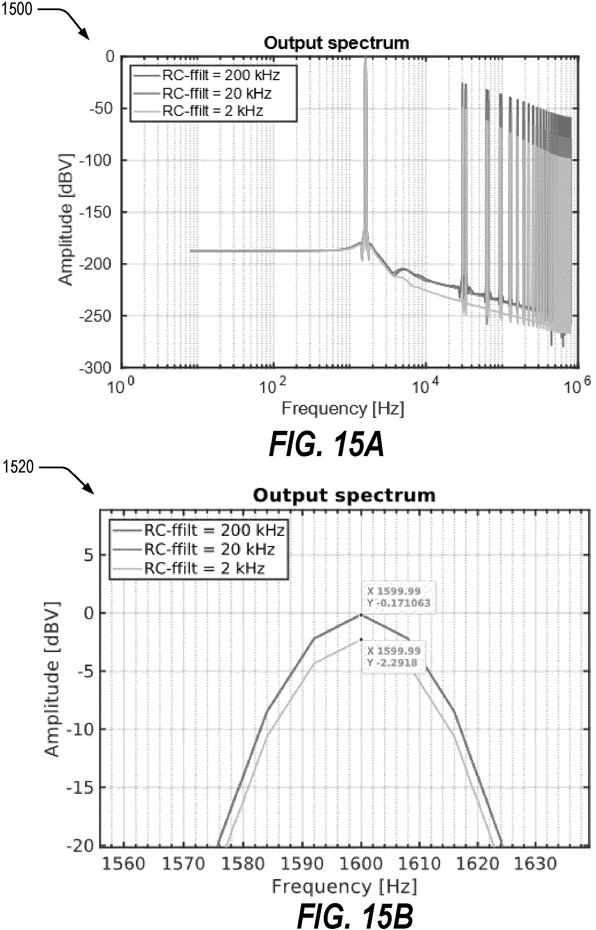

It should be appreciated that the output RC filter provided by the output impedance of the HC sine-wave generator 102 and the capacitor 310 at the output terminal 108 determines a cut-off frequency including the pole beyond which the harmonics are suppressed with a twenty decibel per decade (20 dB/decade) slope. However, if the pole is placed too close to the input frequency, the fundamental frequency may be attenuated. In FIGs. 15A-17, the impact of the location of the RC low-pass filter is depicted with respect to the fundamental tone.

FIG. 15A depicts a graph 1500 of the power spectral density (amplitude versus frequency) for the output spectra of the FIR filter with varying Fast Fourier Transform (FFT) filter values, in accordance with certain embodiments of the present disclosure. In the illustrated graph, the input frequency of the square wave 110 is 1.6 kHz. The graph 1500 depicts the output spectra plotted for the RC cutoff frequency filter of 2 kHz, 20 kHz, and 200 kHz. In this example, the fundamental tone is four divided by pi (2.09 dB) higher than the amplitude of the square wave 110. However, the HC sine-wave generator 102 places notches at the harmonics of the square wave 110, introducing some attenuation (2.2 dB) of the fundamental tone.

FIG. 15B depicts a close up (zoomed in) view 1520 of a portion of the graph 1500 of FIG. 15A, in accordance with certain embodiments of the present disclosure. In this view, difference between the peak amplitude of the 2 kHz implementation and the 20 kHz implementation is approximately 2.2 dB.

Thus, as shown in FIGs. 1-15B and as discussed above, a finite impulse response (FIR) filter architecture can be used to provide an HC sine-wave generator 102. The number of coefficients of the filter may depend on the number of notches implemented to eliminate selected harmonics. By changing the clock frequency ($f_{clk}$), By changing the clock frequency, the input square wave 110 and the frequencies of the notches can be varied, allowing for generation of a frequency-scalable sine wave (output signal $y(t)$) from an input square wave 110.

In one or more embodiments, by using two HC sine-wave generators 102(1) and 102(2), a two-tone sine-wave generator 402 can be built. The frequencies of the clock signals 132(1) and 132(2) may be the same or may be different, and the coefficient values of the taps 206 may be same or different. In one or more embodiments, one or more of the clock frequencies or the coefficient values may be varied to place notches at selected harmonics of the input square waves 110(1) and 112(2) to produce the output signal y(t) with two or more tones and suppressed harmonics. Thus, a frequency-scalable multi-tone sine wave generator can generate a multi-tone sine wave having a selected number of tones from multiple input square-waves independent of the input frequency.

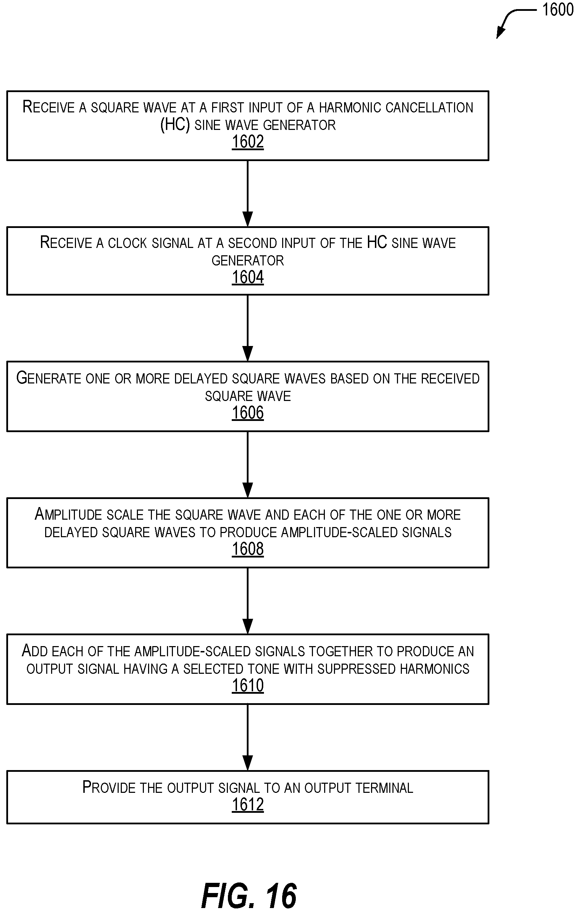

FIG. 16 depicts an embodiment of a method 1600 of generating an output signal having a selected harmonic tone using a harmonic cancellation FIR filter, in accordance with certain embodiments of the present disclosure. At 1602, the method 1600 may include receiving a square wave 110 at an input 104 of an HC sine wave generator 102. The square wave 110 may have a selected period $T_0$ and amplitude.

At 1604, the method 1600 may include receiving a clock signal 132 at a clock input 106 of the HC FIR filter 102. The clock signal 132 may have a selected clock frequency $f_{clk}$.

At 1606, the method 1600 may include generating one or more delayed square waves 130(1), 130(2), ..., 130(n) based on the received square wave 110. The delayed square waves 130 may be generated by delay components 204, such as D flip-flops 302 or another delay component 204.

At 1608, the method 1600 may include amplitude-scaling the square wave 110 and each of the one or more delayed square waves 130 to produce amplitude scaled signals. The HC sine-wave generator 102 may use the resistors 308 of the taps 206 to produce the amplitude scaled signals.

At 1610, the method 1600 may include adding each of the amplitude scaled signals together to produce an output signal $y(t)$ having a selected tone with suppressed harmonics. As discussed above, the taps 206 and the delayed square waves 130 may be configured to suppress selected harmonics in the output signal $y(t)$.

At 1612, the method 1600 may include providing the output signal $y(t)$ to an output terminal 108. In one or more embodiments, the output terminal 108 may be coupled to a low-pass capacitive filter, implemented by the capacitor 310 coupled to the output terminal 108 or to the output node 216(n).

With respect to the embodiment of the method 1600 of FIG. 16, it should be appreciated that the method 1600 is provided for illustrative purposes only and is not intended to be limiting. Changes in the order of the steps may sometimes be made without departing from the scope of the disclosure. For example, though the square wave 110 is received at 1602 and the clock signal 132 is received at 1604, the receipt could be simultaneous or could be reversed without departing from the scope of this disclosure.

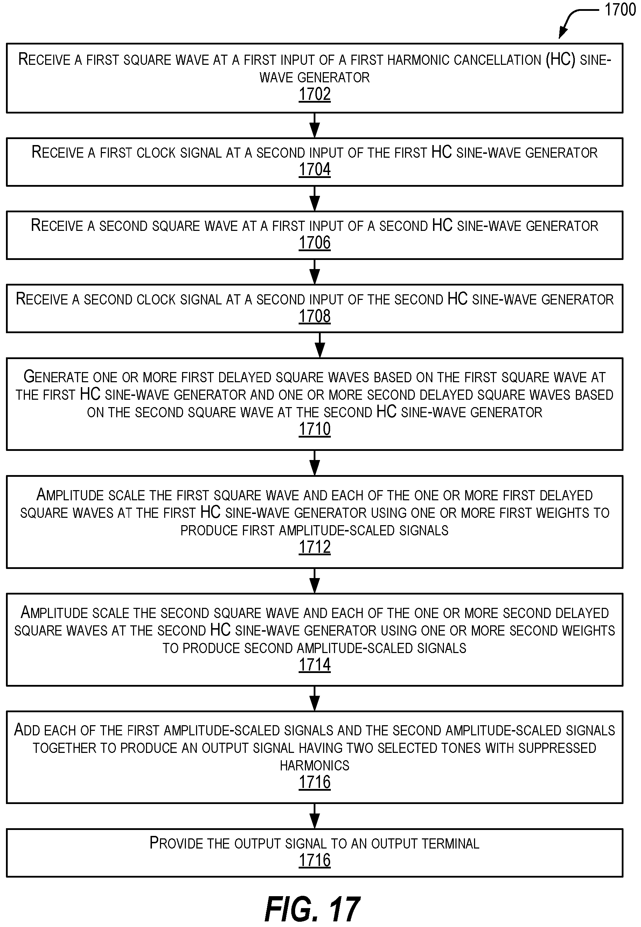

FIG. 17 depicts an embodiment of a method 1700 of generating an output signal having two harmonic tones using a pair of harmonic cancellation FIR filters, in accordance with certain embodiments of the present disclosure. At 1702, the method 1900 may include receiving a first square wave 110(1) at a first input 104(1) of a first HC sine-wave generator 102(1). The first square wave 110(1) may have a first frequency $f_1$.

At 1704, the method 1700 may include receiving a first clock signal 132(1) at a second input (clock input 106(1) of the first HC sine-wave generator 102(1). The first clock signal 132(1) may have a first clock frequency $f_{clk1}$.

At 1706, the method 1700 may include receiving a second square wave 110(2) at a first input 104(2) of a second HC sine-wave generator 102(2). The second square wave 110(2) may have a second frequency $f_2$. In one or more embodiments, the first frequency $f_1$ and the second frequency $f_2$ are different.

At 1708, the method 1700 may include receiving a second clock signal 132(2) at a second input (clock input 106(2) of the second HC sine-wave generator 102(2). The second clock signal 132(2) may have a second clock frequency $f_{clk2}$. In one or more embodiments, the first clock signal 132(1) and the second clock signal 132(2) may have different frequencies or the same frequency.

At 1710, the method 1700 may include generating one or more first delayed square waves 130 based on the first square wave 110(1) at the first HC sine-wave generator 102(1) and one or more second delayed square waves 130' based on the second square wave 110(2) at the second HC sine-wave generator 102(2). The first delayed square waves 130 and second delayed square waves 130' may be generated using delay components 204, such as D flip-flops 302 in FIG. 6.

At 1712, the method 1700 may include amplitude-scaling the first square wave 110(1) and each of the one or more first delayed square waves 130 at the first HC sine-wave generator 102(1) using one or more first weights ($b_0, b_1, ..., b_n$) to produce first amplitude-scaled signals. In one or more embodiments, the first square wave 110(1) and the delayed square waves 130 may be amplitude-scaled using the taps 206. The amplitude-scaled signals may be provided to nodes 212.

At 1714, the method 1700 may include amplitude-scaling the second square wave 110(2) and each of the one or more second delayed square waves 130' at the second HC sinewave generator 102(2) using one or more second weights ($b'_0, b'_1, ..., b'_n$) to produce second amplitude-scaled signals. In one or more embodiments, the second square wave 110(2) and the delayed square waves 130 may be amplitude-scaled using the taps 206'. The amplitude-scaled signals may be provided to nodes 212'.

At 1716, the method 1700 may include adding each of the first amplitude-scaled signals and the second amplitude-scaled signals together to produce an output signal *y(t)* having two selected tones with suppressed harmonics. In this example, summing nodes 214 of the first HC sine-wave generator 102(1) or summing nodes 214' of the second HC sine-wave generator 102(2) may add the amplitude-scaled signals from the nodes 212 and 212' to provide an output signal y(t) to the output node 216(n) or 216'(n), which may be coupled to the output terminal 108.

At 1718, the method 1700 may include providing the output signal *y(t)* to the output terminal 108. The output terminal 108 may be coupled to one or more other circuits to provide the output signal *y(t)* having two tones and suppressed harmonics.

In the embodiment of the method 1700 in FIG. 17, it should be understood that the terms first and second are used to differentiate between different components and are not necessarily indicative of timing or priority. Additionally, though the first square wave 110(1) and the first clock signal 132(1) are discussed in blocks 1702 and 1704, the square wave 110(1) and the clock signal 132(1) may be received simultaneously. Further, blocks 1706 and 1708 mention the second square wave 110(2) and the second clock signal 132(2). It should be understood that blocks 1702-1708 may be performed simultaneously. Similarly, the blocks 1710 and 1712 may be performed simultaneously.

In one or more embodiments, the order of the blocks 1702, 1704, 1706, and 1708 may be rearranged without departing from the scope of the disclosure. Similarly, the order of the block 1710 and 1712 may be rearranged without departing from the scope of the disclosure.

In one or more embodiments, the HC sine-wave generator 102 may receive a square wave having a first frequency and may generate an output signal including a tone at the first frequency with suppressed energy at selected harmonics of the first frequency. Two or more sine-wave generators 102 may be coupled together to produce an output signal with multiple tones at multiple frequencies with suppressed energy at selected harmonics of the multiple frequencies. This disclosure may be further understood based on the following examples.

Example 1: A device may include a harmonic-cancellation (HC) sine-wave generator including: an input configured to receive a square wave having a first frequency with first harmonics; a clock input configured to receive a clock signal having a clock frequency; an output terminal configured to provide an output signal; summing circuitry including a plurality of inputs and including an output coupled to the output terminal; a plurality of delay elements, each delay element including a data input, a second input coupled to the clock input to receive the clock signal, and an output to provide a delayed square wave; a plurality of taps including a first tap and one or more second taps, the first tap including an input coupled to the input to receive the square wave and an output to provide an amplitude-scaled square wave to a first input of the summing circuitry, each of the one or more second taps including an input to receive a delayed square wave from one of the plurality of delay elements and including an output to provide an amplitude-scaled delayed square wave to an associated input of the plurality of inputs of the summing circuitry; and wherein the summing circuitry is configured to add the amplitude-scaled square wave and the one or more amplitude-scaled delayed square waves to produce the output signal including a tone at the first frequency and having suppressed first harmonics at one or more selected frequencies.

Example 2: The device of Example 1, where the plurality of delay elements and the plurality of taps are configured to produce notches at the selected frequencies.

Example 3: The device of any of the Examples 1 or 2, where: the clock frequency and coefficients of the plurality of taps determine the selected frequencies of the notches; and one or more of the clock frequency and the coefficients are changed to alter the selected frequencies of the notches.

Example 4: The device of any of the Examples 1 through 3, where each of the plurality of delay elements includes a D flip flop.

Example 5: The device of any of the Examples 1 through 4, where each of the plurality of taps includes a resistor including a first terminal coupled to one of the plurality of inputs of the summing circuitry and including a second terminal; and a switch including a first terminal coupled to one of the inputs to receive the square wave or one of the output of one of the plurality of delay elements to receive the delayed square wave, a second terminal coupled to the second terminal of the resistor, a first supply terminal to receive a first reference voltage, and a second supply terminal to receive a second reference voltage.

Example 6: The device of Example 5, where the resistors of the plurality of taps have different resistances.

Example 7: The device of Example 5, where the switch of each of the plurality of taps includes: a first transistor including a source coupled to the first reference voltage, a gate coupled to the one of the input to receive the square wave or the output of one of the plurality of delay elements to receive the delayed square wave, and a drain coupled to the second terminal of the resistor; and a second transistor including a source coupled to the second reference voltage, a gate coupled to the gate of the first transistor, and a drain coupled to the second terminal of the resistor.

Example 8: The device of any of the Examples 1 through 7, wherein the plurality of delay elements includes a sequence of delay elements including: a first delay element including a data input coupled to the input to receive the square wave, a second input coupled to the clock input to receive the clock signal, and an output to provide a first delayed square wave to one of the one or more second taps; one or more second delay elements, each second delay element including an input coupled to the output of a previous delay element of the sequence of delay elements, and an output to provide an intermediate delayed square wave to a different one of the one or more second taps; and an N-th delay element including a data input coupled to the output of a previous delay element of the sequence, a second input coupled to the clock input, and an output to provide an n-th delayed square wave to an n-th tap of the one or more second taps.

Example 9: The device of any of the Examples 1 through 8, further comprising a resistor-capacitor (RC) filter coupled to the output terminal.

Example 10: The device of any of the Examples 1 through 9, further includes: a second HC sine-wave generator including: a second input configured to receive a second square wave having a second frequency with second harmonics; a second clock input configured to receive a second clock signal having a second clock frequency; a second plurality of delay elements, each delay element including a data input, a second input coupled to the second clock input to receive the second clock signal, and an output to provide a delayed second square wave; a second plurality of taps including a first tap and one or more second taps, the first tap including an input coupled to the second input to receive the second square wave and an output to provide an amplitude-scaled second square wave to the first input of the summing circuitry, each of the one or more second taps including an input to receive a delayed second square wave from one of the second plurality of delay elements and including an output to provide an amplitude-scaled delayed second square wave to an associated input of the plurality of inputs of the summing circuitry; and wherein the summing circuitry is configured to add the amplitude-scaled square wave, the amplitude-scaled second square wave, the one or more amplitude-scaled delayed square waves, and the one or more amplitude-scaled delayed second square waves to produce the output signal including the tone at the first frequency, a second tone at the second frequency, and the one or more suppressed harmonics at the one or more selected frequencies and at one or more second selected frequencies.

Example 11: The device of Example 10, where the clock frequency and the second clock frequency are the same and a first set of coefficients of the plurality of taps is different from a second set of coefficients of the second plurality of taps.

Example 12: A method including: receiving a square wave having a frequency at an input of a harmonic-cancellation (HC) sine-wave generator; receiving a clock signal having a clock frequency at a clock input of the HC sine-wave generator; generating one or more delayed square waves based on the received square wave and the clock signal using one or more delay components of the HC sine-wave generator; amplitude-scaling the square wave and the one or more delayed square waves using a plurality of taps of the HC sine-wave generator to produce a plurality of amplitude-scaled square waves; adding the plurality of amplitude-scaled square waves using summing circuitry of the HC sine-wave generator to produce a sine wave having tone at the frequency with suppressed signal strength at selected harmonics of the frequency of the square wave; and providing the sine wave to an output terminal of the HC sine-wave generator.

Example 13: The method of Example 12, further including; receiving a second square wave having a second frequency at an input of a second HC sine-wave generator; receiving a second clock signal having a second clock frequency at a clock input of the second HC sine-wave generator; generating one or more delayed second square waves based on the received second square wave and the second clock signal using one or more delay components of the second HC sine-wave generator; and amplitude-scaling the second square wave and the one or more delayed second square waves using a plurality of taps of the second HC sine-wave generator to produce a second plurality of amplitude-scaled square waves.

Example 14: The method of Example 13, where: adding the plurality of amplitude-scaled square waves comprises adding the plurality of amplitude-scaled square waves and the second plurality of amplitude-scaled square waves to produce the output signal; and where the output signal includes the tone corresponding to the frequency of the square wave and a second tone corresponding to the second frequency of the second square wave and including the suppressed signal strength at the selected harmonics of the frequency of the square wave and the second frequency of the second square wave.

Example 15: The method of any of the Examples 13 through 14, further including adjusting one or more of the clock frequency, the second clock frequency, or one or more coefficients associated with the plurality of taps to adjust selected frequencies of notches configured to suppress the selected harmonics of the frequency of the square wave and the second frequency of the second square wave.

Example 16: The method of any of the Examples 12 through 15, further including filtering the output signal at the output terminal using a resistor-capacitor (RC) filter coupled to the output terminal.

Example 17: A device including: a first harmonic-cancellation (HC) sine-wave generator including: a first input to receive a first square wave having a first frequency; a second input to receive a first clock signal having a first clock frequency; an output terminal; first delay elements in a sequence configured to receive the first square wave and the first clock signal and to produce one or more first delayed square waves; one or more first taps configured to produce first amplitude-scaled square waves based on the first square wave and the one or more first delayed square waves; and one or more second HC sine-wave generators, each of the one or more second HC sine-wave generators including: a first input to receive a second square wave having a second frequency; a second input to receive a second clock signal having a second clock frequency; one or more second delay elements in a sequence and configured to receive the second square wave and the second clock signal and to produce one or more second delayed square waves; one or more second taps configured to produce second amplitude-scaled square waves based on the second square wave and the one or more second delayed square waves and to produce the one or more second amplitude-scaled square waves; and summing circuitry configured to add the first amplitude-scaled square waves and one or more of the second amplitude-scaled square waves from the one or more second HC sine-wave generators to produce a sine wave having a first tone at the first frequency and one or more second tones at the one or more second frequencies and including suppressed energy at selected harmonics of the first frequency and the one or more second frequencies, the summing circuitry to provide the sine wave to the output terminal.

Example 18: The device of Example 17, where: the one or more first taps include one or more first resistors coupled to the summing circuitry, the one or more first resistors define a first set of coefficients for the one or more first taps; the one or more second taps including one or more second resistors coupled to the summing circuitry, the one or more second resistors define one or more second sets of coefficients for the one or more second taps; and one or more of the first clock frequency, the one or more second clock frequencies, the first set of coefficients, or the one or more second sets of coefficients are different to produce first notches at first selected harmonics of the first frequency and second notches at second selected harmonics of the one or more second frequencies.

Example 19: The device of any of the Examples 17 through 18, where the first clock frequency and the one or more second clock frequencies are the same and a first set of coefficients of the first HC sine-wave generator and one or more second sets of coefficients of the one or more second HC sine-wave generators are different.

Example 20: The device of any of the Examples 17-19, where the first clock frequency and the one or more second clock frequencies are different, and a first set of coefficients of the first HC sine-wave generator and one or more second sets of coefficients of the one or more second HC sine-wave generators are different.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

**Claims**

1.  A device comprises:

    a harmonic-cancellation (HC) sine-wave generator comprising:

       an input configured to receive a square wave having a first frequency with first harmonics;
       a clock input configured to receive a clock signal having a clock frequency;
       an output terminal configured to provide an output signal;
       summing circuitry including a plurality of inputs and including an output coupled to the output terminal;
       a plurality of delay elements, each delay element including a data input, a second input coupled to the clock input to receive the clock signal, and an output to provide a delayed square wave;

a plurality of taps including a first tap and one or more second taps, the first tap including an input coupled to the input to receive the square wave and an output to provide an amplitude-scaled square wave to a first input of the summing circuitry, each of the one or more second taps including an input to receive a delayed square wave from one of the plurality of delay elements and including an output to provide an amplitude-scaled delayed square wave to an associated input of the plurality of inputs of the summing circuitry; and

wherein the summing circuitry is configured to add the amplitude-scaled square wave and the one or more amplitude-scaled delayed square waves to produce the output signal including a tone at the first frequency and having suppressed first harmonics at one or more selected frequencies.

2. The device of claim 1, wherein the plurality of delay elements and the plurality of taps are configured to produce notches at the selected frequencies.

3. The device of claim 2, wherein:

the clock frequency and coefficients of the plurality of taps determine the selected frequencies of the notches; and
one or more of the clock frequency and the coefficients are changed to alter the selected frequencies of the notches.

4. The device according to any preceding claim, wherein each of the plurality of delay elements comprises a D flip flop.

5. The device according to any preceding claim, wherein each of the plurality of taps comprises:

a resistor including a first terminal coupled to one of the plurality of inputs of the summing circuitry and including a second terminal; and
a switch including a first terminal coupled to one of the inputs to receive the square wave or one of the output of one of the plurality of delay elements to receive the delayed square wave, a second terminal coupled to the second terminal of the resistor, a first supply terminal to receive a first reference voltage, and a second supply terminal to receive a second reference voltage.

6. The device of claim 5, wherein the resistors of the plurality of taps have different resistances.

7. The device of claim 5, wherein the switch of each of the plurality of taps comprises:

a first transistor including a source coupled to the first reference voltage, a gate coupled to the one of the input to receive the square wave or the output of one of the plurality of delay elements to receive the delayed square wave, and a drain coupled to the second terminal of the resistor; and
a second transistor including a source coupled to the second reference voltage, a gate coupled to the gate of the first transistor, and a drain coupled to the second terminal of the resistor.

8. The device according to any preceding claim, wherein the plurality of delay elements includes a sequence of delay elements comprising:

a first delay element including a data input coupled to the input to receive the square wave, a second input coupled to the clock input to receive the clock signal, and an output to provide a first delayed square wave to one of the one or more second taps;
one or more second delay elements, each second delay element including an input coupled to the output of a previous delay element of the sequence of delay elements, and an output to provide an intermediate delayed square wave to a different one of the one or more second taps; and
an N-th delay element including a data input coupled to the output of a previous delay element of the sequence, a second input coupled to the clock input, and an output to provide an n-th delayed square wave to an n-th tap of the one or more second taps.

9. The device according to any preceding claim, further comprising a resistor-capacitor (RC) filter coupled to the output terminal.

10. The device according to any preceding claim, further comprising:
a second HC sine-wave generator comprising:

a second input configured to receive a second square wave having a second frequency with second harmonics;

a second clock input configured to receive a second clock signal having a second clock frequency;

a second plurality of delay elements, each delay element including a data input, a second input coupled to the second clock input to receive the second clock signal, and an output to provide a delayed second square wave;

a second plurality of taps including a first tap and one or more second taps, the first tap including an input coupled to the second input to receive the second square wave and an output to provide an amplitude-scaled second square wave to the first input of the summing circuitry, each of the one or more second taps including an input to receive a delayed second square wave from one of the second plurality of delay elements and including an output to provide an amplitude-scaled delayed second square wave to an associated input of the plurality of inputs of the summing circuitry; and

wherein the summing circuitry is configured to add the amplitude-scaled square wave, the amplitude-scaled second square wave, the one or more amplitude-scaled delayed square waves, and the one or more amplitude-scaled delayed second square waves to produce the output signal including the tone at the first frequency, a second tone at the second frequency, and the one or more suppressed harmonics at the one or more selected frequencies and at one or more second selected frequencies.

11. The device of claim 10, wherein the clock frequency and the second clock frequency are the same and a first set of coefficients of the plurality of taps is different from a second set of coefficients of the second plurality of taps.

12. A method comprising:

receiving a square wave having a frequency at an input of a harmonic-cancellation (HC) sinewave generator;

receiving a clock signal having a clock frequency at a clock input of the HC sine-wave generator;

generating one or more delayed square waves based on the received square wave and the clock signal using one or more delay components of the HC sine-wave generator;

amplitude-scaling the square wave and the one or more delayed square waves using a plurality of taps of the HC sine-wave generator to produce a plurality of amplitude-scaled square waves;

adding the plurality of amplitude-scaled square waves using summing circuitry of the HC sinewave generator to produce a sine wave having tone at the frequency with suppressed signal strength at selected harmonics of the frequency of the square wave; and

providing the sine wave to an output terminal of the HC sine-wave generator.

13. The method of claim 12, further comprising;

receiving a second square wave having a second frequency at an input of a second HC sinewave generator;

receiving a second clock signal having a second clock frequency at a clock input of the second HC sine-wave generator;

generating one or more delayed second square waves based on the received second square wave and the second clock signal using one or more delay components of the second HC sine-wave generator; and

amplitude-scaling the second square wave and the one or more delayed second square waves using a plurality of taps of the second HC sine-wave generator to produce a second plurality of amplitude-scaled square waves.

14. The method of claim 13, wherein:

adding the plurality of amplitude-scaled square waves comprises adding the plurality of amplitude-scaled square waves and the second plurality of amplitude-scaled square waves to produce the output signal; and

wherein the output signal includes the tone corresponding to the frequency of the square wave and a second tone corresponding to the second frequency of the second square wave and including the suppressed signal strength at the selected harmonics of the frequency of the square wave and the second frequency of the second square wave.

15. The method of claim 13, further comprising adjusting one or more of the clock frequency, the second clock frequency, or one or more coefficients associated with the plurality of taps to adjust selected frequencies of notches configured to suppress the selected harmonics of the frequency of the square wave and the second frequency of the second square wave.

**FIG. 1A**

$$T_0 = \frac{1}{f_0}$$

**FIG. 1B**

FIG. 2

**FIG. 3**

400

$f_{clk1}$

132(1)

106(1)

HC SINE-WAVE TWO-TONE
GENERATOR
402

110(1)

$x_1(t)$

104(1)

HC SINE-WAVE
GENERATOR
102(1)

216(n1)

$y_1(t)$

108

$\Sigma$
404

$y(t)$

110(2)

$x_2(t)$

104(2)

HC SINE-WAVE
GENERATOR
102(2)

216(n2)

$y_2(t)$

106(2)

$f_{clk2}$

132(2)

**FIG. 4**

*FIG. 5*

**FIG. 6**

**FIG. 7A**

**FIG. 7B**

800 ⟶

Time-Domain Plot of Summed Wave

FIG. 8A

820 ⟶

PSD of Summed Waveform

........ fs/2
— — Inband Bins
—— Main Tone

PSD (dB)

Frequency (Hz)

FIG. 8B

FIG. 9A

FIG. 9B

1000 →

FIG. 10A

1020 →

FIG. 10B

FIG. 11A

FIG. 11B

FIG. 12A

FIG. 12B

1300 —

**FIG. 13A**

1320 —

**FIG. 13B**

1400 —

**Output spectrum**

*FIG. 14A*

1420 —

**Output spectrum**

*FIG. 14B*

1500

FIG. 15A

1520

FIG. 15B

1600

RECEIVE A SQUARE WAVE AT A FIRST INPUT OF A HARMONIC CANCELLATION (HC) SINE WAVE GENERATOR
1602

RECEIVE A CLOCK SIGNAL AT A SECOND INPUT OF THE HC SINE WAVE GENERATOR
1604

GENERATE ONE OR MORE DELAYED SQUARE WAVES BASED ON THE RECEIVED SQUARE WAVE
1606

AMPLITUDE SCALE THE SQUARE WAVE AND EACH OF THE ONE OR MORE DELAYED SQUARE WAVES TO PRODUCE AMPLITUDE-SCALED SIGNALS
1608

ADD EACH OF THE AMPLITUDE-SCALED SIGNALS TOGETHER TO PRODUCE AN OUTPUT SIGNAL HAVING A SELECTED TONE WITH SUPPRESSED HARMONICS
1610

PROVIDE THE OUTPUT SIGNAL TO AN OUTPUT TERMINAL
1612

FIG. 16

1700

RECEIVE A FIRST SQUARE WAVE AT A FIRST INPUT OF A FIRST HARMONIC CANCELLATION (HC) SINE-
WAVE GENERATOR
1702

RECEIVE A FIRST CLOCK SIGNAL AT A SECOND INPUT OF THE FIRST HC SINE-WAVE GENERATOR
1704

RECEIVE A SECOND SQUARE WAVE AT A FIRST INPUT OF A SECOND HC SINE-WAVE GENERATOR
1706

RECEIVE A SECOND CLOCK SIGNAL AT A SECOND INPUT OF THE SECOND HC SINE-WAVE GENERATOR
1708

GENERATE ONE OR MORE FIRST DELAYED SQUARE WAVES BASED ON THE FIRST SQUARE WAVE AT
THE FIRST HC SINE-WAVE GENERATOR AND ONE OR MORE SECOND DELAYED SQUARE WAVES BASED
ON THE SECOND SQUARE WAVE AT THE SECOND HC SINE-WAVE GENERATOR
1710

AMPLITUDE SCALE THE FIRST SQUARE WAVE AND EACH OF THE ONE OR MORE FIRST DELAYED
SQUARE WAVES AT THE FIRST HC SINE-WAVE GENERATOR USING ONE OR MORE FIRST WEIGHTS TO
PRODUCE FIRST AMPLITUDE-SCALED SIGNALS
1712

AMPLITUDE SCALE THE SECOND SQUARE WAVE AND EACH OF THE ONE OR MORE SECOND DELAYED
SQUARE WAVES AT THE SECOND HC SINE-WAVE GENERATOR USING ONE OR MORE SECOND WEIGHTS
TO PRODUCE SECOND AMPLITUDE-SCALED SIGNALS
1714

ADD EACH OF THE FIRST AMPLITUDE-SCALED SIGNALS AND THE SECOND AMPLITUDE-SCALED SIGNALS
TOGETHER TO PRODUCE AN OUTPUT SIGNAL HAVING TWO SELECTED TONES WITH SUPPRESSED
HARMONICS
1716

PROVIDE THE OUTPUT SIGNAL TO AN OUTPUT TERMINAL
1716

*FIG. 17*

Europäisches
Patentamt

European
Patent Office

Office européen
des brevets

## EUROPEAN SEARCH REPORT

**Application Number**

EP 25 19 0843

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MALLOUG HANI ET AL: "Mostly-digital design of sinusoidal signal generators for mixed-signal BIST applications using harmonic cancellation", 2016 IEEE 21ST INTERNATIONAL MIXED-SIGNAL TESTING WORKSHOP (IMSTW), IEEE, 4 July 2016 (2016-07-04), pages 1-6, XP032936295, DOI: 10.1109/IMS3TW.2016.7524231 [retrieved on 2016-07-27] * section III, par. 1; figure 1 * | 1,2,4-8, 10-15 | INV. H03B21/00 H03B28/00 |
| X | MALLOUG HANI ET AL: "Practical Harmonic Cancellation Techniques for the On-Chip Implementation of Sinusoidal Signal Generators for Mixed-Signal BIST Applications", JOURNAL OF ELECTRONIC TESTING, KLUWER ACADEMIC PUBLISHERS, DORDRECHT, NL, vol. 34, no. 3, 22 March 2018 (2018-03-22), pages 263-279, XP036507782, ISSN: 0923-8174, DOI: 10.1007/S10836-018-5720-2 [retrieved on 2018-03-22] * page 265, column 1, lines 11-15 - page 266, column 1, paragraph 1; figure 7 * | 1-4,8-15 | |
| A | US 2010/018383 A1 (THIRUMOORTHY HARI [US]) 28 January 2010 (2010-01-28) * figure 1 * | 10,11, 13-15 | TECHNICAL FIELDS SEARCHED (IPC) H03B |

-/--

The present search report has been drawn up for all claims

| Place of search | Date of completion of the search | Examiner |
|---|---|---|
| Munich | 9 December 2025 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 25 19 0843

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZHIHENG CAO ET AL: "A 14 mW 2.5 MS/s 14 bit Modulator Using Split-Path Pseudo-Differential Amplifiers", IEEE JOURNAL OF SOLID-STATE CIRCUITS, IEEE, USA, vol. 42, no. 10, 31 October 2007 (2007-10-31), pages 2169-2179, XP011193055, ISSN: 0018-9200, DOI: 10.1109/JSSC.2007.905241 * page 2177, column 1, lines 3-5 * ----- | 10,11, 13-15 | |

**TECHNICAL FIELDS SEARCHED (IPC)**

The present search report has been drawn up for all claims

| Place of search | Date of completion of the search | Examiner |
|---|---|---|
| Munich | 9 December 2025 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 0843

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2025

| Patent document cited in search report | Publication date | Patent family member(s) | Publication date |
|---|---|---|---|
| US 2010018383 A1 | 28-01-2010 | NONE | |

EPO FORM P0459

For more details about this annex : see Official Journal of the European Patent Office, No. 12/82